(19) Europäisches Patentamt
European Patent Office
Office européen des brevets

(11) EP 2 003 500 A2

(12) **EUROPEAN PATENT APPLICATION**

(43) Date of publication:
**17.12.2008 Bulletin 2008/51**

(51) Int Cl.:
*G03F 7/00* (2006.01) *G03F 7/029* (2006.01)

(21) Application number: **08010547.1**

(22) Date of filing: **10.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **11.06.2007 JP 2007153447**

(71) Applicant: **FUJIFILM Corporation**
**Minato-ku**
**Tokyo (JP)**

(72) Inventor: **Yamada, Satoru**
**Kanagawa 258-8577 (JP)**

(74) Representative: **HOFFMANN EITLE**
**Patent- und Rechtsanwälte**
**Arabellastrasse 4**
**81925 München (DE)**

(54) **Optical recording composition, holographic recording medium, and method of recording and reproducing information**

(57) The present invention provides an optical recording composition comprising a radical polymerizable monomer having a wavelength $\lambda_1$ nm within an absorption spectrum ranging from 200 to 1,000 nm, the radical polymerizable monomer exhibiting a molar absorbance coefficient of equal to or greater than 5,000 mole·1·cm$^{-1}$ at the wavelength $\lambda_1$ nm, a titanocene radical polymerization initiator, a polyfunctional isocyanate, and a polyfunctional alcohol.

Fig. 1

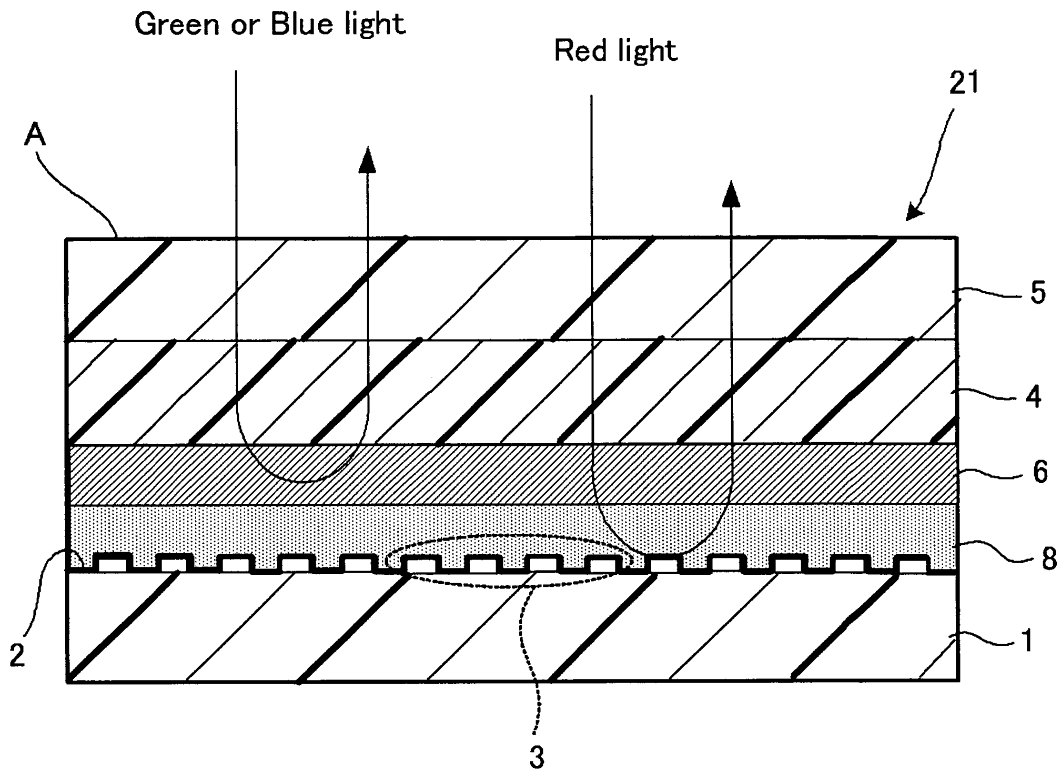


EP 2 003 500 A2

## Description

BACKGROUND OF THE INVENTION

FIELD OF THE INVENTION

The present invention relates to an optical recording composition suited to the manufacturing of an optical recording medium which records information using holography. The present invention further relates to a holographic recording medium formed with the above optical recording composition and a method of recording and reproducing information using the above medium.

DISCUSSION OF THE BACKGROUND

One example of recording media permitting the writing of large amounts of data such as high-density image data is an optical recording medium. Optical recording media have already been put to practical use in the form of rewritable optical recording media such as magneto-optical disks and phase-change optical disks, and recordable optical recording media such as the CD-R.

In recent years, demand for even greater capacity in optical recording media has increased steadily. However, all the optical recording media that have been proposed thus far employ two-dimensional recording and afford limited increases in recording capacity. Accordingly, hologram-type optical recording media (holographic recording media) capable of recording information in three dimensions have recently been attracting attention.

Generally, in hologram-type optical recording methods, an informing light imparted with a two-dimensional intensity distribution and a reference light with an intensity that is roughly constant with that of the informing light are superposed within the photosensitive recording layer, and the interference image they form is used to generate an optical characteristic distribution within the recording layer to record information. When reading (reproducing) the information that has been written, the recording layer is irradiated with just the reference light positioned as during recording, causing a reproduction light having an intensity distribution corresponding to the optical characteristic distribution formed in the recording layer to exit the recording layer.

In the hologram-type optical recording methods, an optical characteristic distribution is formed three-dimensionally within the recording layer. Thus, a region in which information is written by one reference light and a region in which information is written by another reference light can be partially superposed. That is, multiplexed recording is possible. When employing digital volume holography, since the signal-to-noise ratio (S/N ratio) at a single spot is extremely high, the original information can be faithfully reproduced even with some drop in S/N ratio due to overwriting. As a result, multiplexed recording of as many as several hundred regions is possible, permitting a marked increase in the recording capacity of the optical recording medium (see Japanese Unexamined Patent Publication (KOKAI) No. 2002-123949 or English language family member US 2004/0042374 Al). In particular, volume holography is a system in which the direction of thickness of the optical recording medium is actively utilized to write three-dimensional interference fringes. It affords advantages in that the thickness can be increased to enhance diffraction efficiency, and multiplexed recording can be employed to increase recording capacity.

Photopolymer-type recording media are known among such hologram-type recording media. For example, Japanese Unexamined Patent Publication (KOKAI) Heisei No. 6-43634 or U.S. Patent No. 4,942,112 proposes a photopolymer-type optical recording composition, chiefly comprised of a radical polymerizable monomer, binder polymer, optical radical polymerization initiator, and sensitizing dye, where the difference in refractive index between the radical polymerization monomer and the binder polymer is used. In the optical recording medium described in Japanese Unexamined Patent Publication (KOKAI) Heisei No. 6-43634, radical polymerization begins in areas where the light is intense when a film-like recording layer formed with the optical recording composition is interference exposed, creating a density gradient in the radical polymerization monomer and causing the radical polymerization monomer to diffuse and migrate from portions where the light is weak to portions where the light is strong. As a result, variation in the intensity of the interference light produces variation in the density of the radical polymerization monomer, appearing in the form of a difference in the refractive index.

U.S. Patent No. 6,482,551 proposes a photopolymer-type photosensitive composition for volumetric holography comprising a titanocene initiator, acrylate monomer, and a polymer matrix precursor of NCO-terminal prepolymer and polyol. The technique described in Patent U.S. Patent No. 6,482,551 permits the manufacturing of a holographic recording medium without the coating with a solvent by depositing the polymer matrix precursor to a prescribed thickness between two pieces of base material and then reacting the precursor to obtain a polymer matrix. Holographic recording is then achieved by interference exposure of the holographic optical recording medium thus manufactured.

However, the sensitivity of conventional photopolymer-type holographic recording media such as those described in Japanese Unexamined Patent Publication (KOKAI) Heisei No. 6-43634, U.S. Patent No. 6,482,551, and the like is not

necessarily adequate for volume holographic recording media and requires further improvement.

Variation in refractive index density is important to achieving high sensitivity and highly multiplexed recording in holographic recording media. The Kramers-Kroning relations generally apply to the absorption spectra and refractive index dispersion of a material; the refractive index increases with proximity to the base on the long wavelength side in the absorption spectrum of a material. Accordingly, the closer the reading wavelength is to the base on the long wavelength side in the absorption spectrum of a monomer, the greater the difference in refractive index, which is advantageous from the perspectives of sensitivity and degree of multiplexing. On the other hand, when the molar absorbance coefficient of the monomer at the reading wavelength is high, optical reading sensitivity diminishes. Accordingly, Japanese Unexamined Patent Publication (KOKAI) No. 2005-275158 proposes specifying the absorption characteristics of a dye monomer employed as a recording material. The technique described in Japanese Unexamined Patent Publication (KOKAI) No. 2005-275158 permits enhanced sensitivity through the combination of a dye monomer, sensitizing dye, and initiator, but still cannot be considered to afford adequate sensitivity for practical purposes; further improvement in sensitivity is needed.

As set forth above, holographic recording media require greater sensitivity and the achievement of a higher degree of multiplexed recording (greater recording capacity).

SUMMARY OF THE INVENTION

An aspect of the present invention provides for an optical recording composition that permits a high degree of multiplexed recording with high sensitivity, and for a highly sensitive hologram-type optical recording medium permitting a high degree of multiplexed recording of interference images formed by an informing light and reference light.

The present inventors conducted extensive research, resulting in the discovery that recording sensitivity and recording capacity could be enhanced by employing in combination a radical polymerizable monomer having absorption in the form of a molar absorbance coefficient of equal to or greater than 5,000 mole·1·$cm^{-1}$ in the wavelength range of 200 to 1,000 nm; a titanocene radical polymerization initiator; and a polyfunctional isocyanate and polyfunctional alcohol capable of forming a polyurethane matrix. The present invention was devised on that basis.

An aspect of the present invention relates to an optical recording composition comprising:

a radical polymerizable monomer having a wavelength $\lambda_1$ nm within an absorption spectrum ranging from 200 to 1,000 nm, the radical polymerizable monomer exhibiting a molar absorbance coefficient of equal to or greater than 5,000 mole·1·$cm^{-1}$ at the wavelength $\lambda_1$ nm;
a titanocene radical polymerization initiator;
a polyfunctional isocyanate; and
a polyfunctional alcohol.

The wavelength $\lambda_1$ may be a maximum absorption wavelength of the radical polymerizable monomer.

The radical polymerizable monomer may exhibit a molar absorbance coefficient of equal to or smaller than 100 mole·1·$cm^{-1}$ at the wavelength $\lambda_2$ nm within an absorption spectrum ranging from 350 to 750 nm.

The titanocene radical polymerization initiator may be a titanocene radical polymerization initiator denoted by general formula (I).

General formula (I)

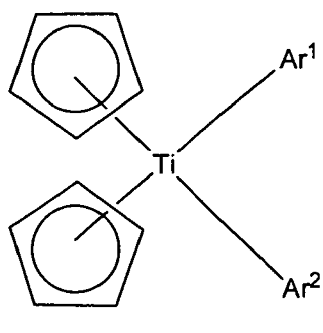

In general formula (I), $Ar^1$ and $Ar^2$ each independently denote an optionally substituted aryl group.

The titanocene radical polymerization initiator denoted by general formula (I) may be a titanocene radical polymerization initiator denoted by general formula (II).

General formula (II)

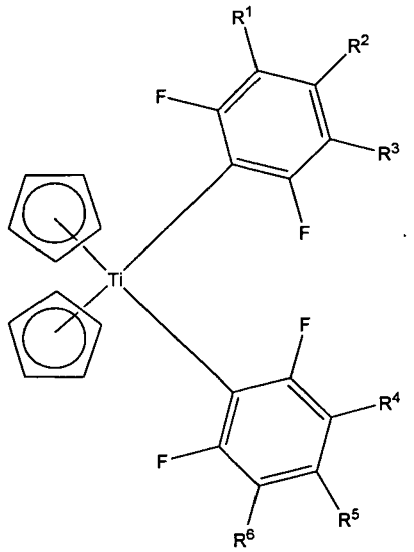

In general formula (II), $R^1$ to $R^6$ each independently denote a hydrogen atom, halogen atom, or heterocyclic group.

The titanocene radical polymerization initiator may be at least one selected from the group consisting of bis(η-5-2,4-cyclopentadien-1-yl) bis[2,6-difluoro-3-(1H-pyrrole-1-yl)]phenyltitanium, bis(η-5-2,4-cyclopentadien-1-yl) bis(2,6-difluoro)phenyltitanium, and bis(η-5-2,4-cyclopentadien-1-yl) bis(2,3,4,5,6-pentafluoro)phenyltitanium.

The radical polymerizable monomer may comprise at least one selected from the group consisting of radical polymerizable monomers denoted by general formulas (C-1), (C-2), (C-3), (C-4), (C-5) and (C-6).

(C-1)

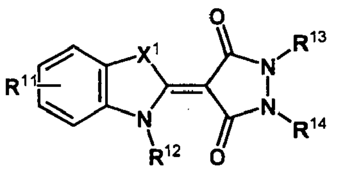

(C-2)

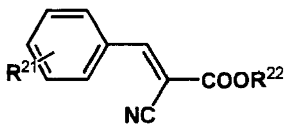

(C-3)

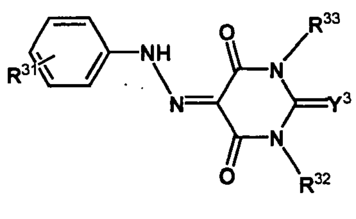

(C-4)

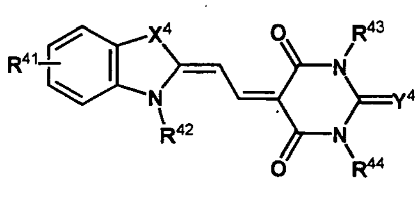

(C-5)

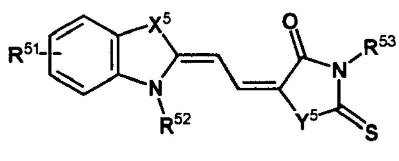

(C-6)

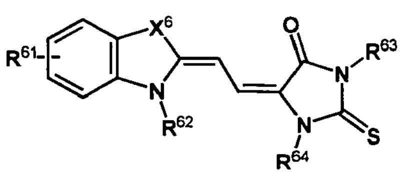

In the above formulas, $R^{11}$, $R^{21}$, $R^{31}$, $R^{41}$, $R^{51}$, and $R^{61}$ each independently denote a hydrogen atom, halogen atom, radical polymerizable group, optionally radical polymerizable group-substituted alkyl group, aryl group, heterocyclic group, alkoxy group, aryloxy group, alkoxycarbonyl group, aryloxycarbonyl group, carbamoyl group, sulfamoyl group, amino group, acyloxy group, acylamino group, hydroxyl group, carboxylic acid group, or sulfonic acid group; $R^{12}$ $R^{13}$, $R^{14}$, $R^{22}$, $R^{32}$, $R^{33}$, $R^{42}$, $R^{43}$, $R^{44}$, $R^{52}$, $R^{53}$, $R^{62}$ $R^{63}$, and $R^{64}$ each independently denote a hydrogen atom, radical polymerizable group, optionally radical polymerizable group-substituted alkyl group, aryl group, or heterocyclic group; $X^1$, $X^4$, $X^5$ and $X^6$ each independently denote an oxygen atom, sulfur atom, selenium atom, or $CRa_2$, where Ra denotes a hydrogen atom or alkyl group; and $Y^3$ and $Y^4$ each independently denote an oxygen atom, sulfur atom, or selenium atom. In general formula (C-1), at least one from among $R^{11}$ to $R^{14}$ comprises a radical polymerizable group; in general formula (C-2), at least one from among $R^{21}$ and $R^{22}$ comprises a radical polymerizable group; in general formula (C-3), at least one from among $R^{31}$ to $R^{33}$ comprises a radical polymerizable group; in general formula (C-4), at least one from among $R^{41}$ to $R^{44}$ comprises a radical polymerizable group; in general formula (C-5), at least one from among $R^{51}$ to $R^{53}$ comprises a radical polymerizable group; and in general formula (C-6), at least one from among $R^{61}$ to $R^{63}$ comprises a radical polymerizable group.

The optical recording composition may be a holographic recording composition.

Another aspect of the present invention relates to a holographic recording medium comprising a recording layer, wherein the recording layer is formed with the above holographic recording composition.

A further aspect of the present invention relates to a method of recording and reproducing information comprising:

irradiating the above holographic recording medium with an informing light and a reference light to form an interference image in the recording layer comprised in the holographic recording medium; and

irradiating the holographic recording medium in which the interference image has been formed with a reproduction light.

The method of recording and reproducing information may employs a light with a wavelength $\lambda_3$ nm satisfying the following equation (1) as the reproduction light.

$$\lambda_3 - 100 \leq \lambda_1 < \lambda_3 \cdots (1)$$

The present invention can provide an optical recording composition permitting a high degree of multiplexed recording with high sensitivity that can solve the problems in conventional holographic recording media. Further, the optical recording composition of the present invention can be excellent in fixing property. This optical recording composition can also be employed to obtain a holographic recording medium suited to use in digital volume holography permitting ultrahigh-density optical recording.

Other exemplary embodiments and advantages of the present invention may be ascertained by reviewing the present disclosure and the accompanying drawings.

## BRIEF DESCRIPTION OF THE DRAWINGS

The present invention will be described in the following text by the exemplary, non-limiting embodiments shown in the figures, wherein:

Fig. 1 is a schematic cross-sectional view of an example of a holographic recording medium according to a first implementation embodiment.

Fig. 2 is a schematic cross-sectional view of an example of a holographic recording medium according to a second implementation embodiment.

Fig. 3 is a drawing descriptive of an example of an optical system permitting recording and reproducing of information on a holographic recording medium.

Fig. 4 is a block diagram showing an example of the overall configuration of a recording and reproducing device suited to use in recording and reproducing information on the holographic recording medium of the present invention.

Explanations of symbols in the drawings are as follows:

1 Lower substrate

| | |
|---|---|
| 2 | Reflective film |
| 3 | Servo pit pattern |
| 4 | Recording layer |
| 5 | Upper substrate |
| 6 | Filter layer |
| 7 | Second gap layer |
| 8 | First gap layer |
| 12 | Objective lens |
| 13 | Dichroic mirror |
| 14 | Detector |
| 15 | 1/4 wavelength plate |
| 16 | Polarizing plate |
| 17 | Half mirror |
| 20 | Holographic recording medium |
| 21 | Holographic recording medium |
| 22 | Holographic recording medium |
| 31 | Pickup |
| 81 | Spindle |
| 82 | Spindle motor |
| 83 | Spindle servo circuit |
| 84 | Driving device |
| 85 | Detection circuit |
| 86 | Focus servo circuit |
| 87 | Tracking servo circuit |
| 88 | Slide servo circuit |
| 89 | Signal processing circuit |
| 90 | Controller |
| 91 | Operation element |
| 100 | Optical recording and reproducing device |

A Entry and exit surface

FE Focus error signal

TE Tracking error signal

RF Reproduction signal

DETAILED DESCRIPTIONS OF THE EMBODIMENTS

The following preferred specific embodiments are, therefore, to be construed as merely illustrative, and non-limiting to the remainder of the disclosure in any way whatsoever. In this regard, no attempt is made to show structural details of the present invention in more detail than is necessary for fundamental understanding of the present invention; the description taken with the drawings making apparent to those skilled in the art how several forms of the present invention may be embodied in practice.

OPTICAL RECORDING COMPOSITION

The optical recording composition of the present invention comprises:

a radical polymerizable monomer having a wavelength $\lambda_1$ nm within an absorption spectrum ranging from 200 to 1,000 nm, the radical polymerizable monomer exhibiting a molar absorbance coefficient of equal to or greater than 5,000 mole·1·cm$^{-1}$ at the wavelength $\lambda_1$ nm;
a titanocene radical polymerization initiator;
a polyfunctional isocyanate; and
a polyfunctional alcohol.

The optical recording composition of the present invention is preferably employed as a holographic recording composition, and is particularly suitable as a volume holographic recording composition. As set forth above, holographic recording is a method of recording information by superposing an informing light containing information and a reference light in a recording layer to write an interference image thus formed in the recording layer. Volume holographic recording is a method of recording information in holographic recording in which a three-dimensional interference image is written in the recording layer.

The optical recording composition of the present invention will be described in detail below.

Radical polymerizable monomer

The optical recording composition of the present invention comprises a radical polymerizable monomer having a wavelength $\lambda_1$ nm within an absorption spectrum ranging from 200 to 1,000 nm, the radical polymerizable monomer exhibiting a molar absorbance coefficient of equal to or greater than 5,000 mole·1·cm$^{-1}$ at the wavelength $\lambda_1$ nm. The molar absorbance coefficient is preferably equal to or greater than 10,000 mole·1·cm$^{-1}$. The upper limit thereof is not specifically limited, and may be about 200,000 mole·1·cm$^{-1}$.

The maximum absorption of the radical polymerizable monomer may be at a wavelength of other than $\lambda_1$, but is preferably at $\lambda_1$. The molar absorbance coefficient at the maximum absorption wavelength is preferably equal to or greater than 10,000 mole·1·cm$^{-1}$, more preferably equal to or greater than 30,000 mole·1·cm$^{-1}$, and further preferably, equal to or greater than 100,000 mole·1·cm$^{-1}$. The upper limit of the molar absorbance coefficient at the maximum absorption is not specifically limited, and can be about 200,000 mole·1·cm$^{-1}$, for example.

Wavelength $\lambda_1$ is preferably shorter than the wavelength of the light (reproduction light) used to reproduce information that has been recorded on the recording medium formed with the optical recording composition of the present invention. Specifically, when the wavelength of the reproduction light is denoted as $\lambda_3$, the following relation is preferably satisfied:

$$(\lambda_3 - 100) \leq \lambda_1 < \lambda_3.$$

Further, with the wavelength $\lambda_3$ of the reproduction light, the maximum absorption wavelength of the radical polymerizable monomer preferably satisfies:

$$(\lambda_3 - 70) \leq \text{maximum absorption wavelength} \leq (\lambda_3 - 20)$$

and more preferably satisfies:

$$(\lambda_3 - 50) \leq \text{maximum absorption wavelength} \leq (\lambda_3 - 20).$$

Wavelength $\lambda_3$ of the light (reproduction light) used to reproduce information recorded in a recording medium formed using the optical recording composition of the present invention preferably falls within a range of 350 to 750 nm, more preferably within a range of 400 to 550 nm. A laser beam having a wavelength of 405 nm or 532 nm is particularly preferable as the reproduction light. From the perspectives of high sensitivity and a high degree of multiplexed recording, the radical polymerizable monomer preferably does not have absorption at the wavelength of the reproduction light. In this context, the phrase "does not have absorption" means that the molar absorbance coefficient of the radical polymerizable monomer is equal to or less than 100 mole·1·cm$^{-1}$, is preferably equal to or less than 50 mole·1·cm$^{1}$, and most preferably, is 0 mole·1·cm$^{-1}$
That is, it is preferable for the radical polymerizable monomer to have a wavelength (wavelength $\lambda_2$ nm) at which the molar absorbance coefficient is equal to or less than 100 mole·1·cm$^{-1}$ preferably equal to or less than 50 mole·1·cm$^{-1}$, and more preferably, 0 mole/1/cm$^{-1}$ over an absorption spectrum ranging from 350 to 750 nm (preferably a range of 400 to 550 nm, more preferably 405 or 532 nm).
The present invention can achieve high sensitivity and a high degree of multiplexed recording by employing a polymerizable polymer in the form of a compound having such optimal absorption characteristics in combination with a titanocene radical polymerization initiator and polyurethane binder-forming components, described further below.

In the present invention, the term "molar absorbance coefficient" means, for example, the molar absorbance coefficient in the form of a value measured with a spectrophotometer for the ultraviolet and visible regions for a solution obtained by dissolving the polymerizable monomer in a solvent that will dissolve monomers, such as methylene chloride, chloroform, methanol, or acetonitrile.

The content of the polymerizable monomer having the above absorption characteristics in the optical recording composition of the present invention is preferably 1 to 40 weigh percent, more preferably 3 to 30 weight percent. When the content is equal to or greater than 1 weight percent, an improvement in sensitivity can be achieved; at equal to or lower than 40 weight percent, good multiplexing characteristics can be achieved. The above radical polymerizable monomers may be employed singly or in combinations of two or more.

The radical polymerizable monomers denoted by general formulas (C-1), (C-2), (C-3), (C-4), (C-5), and (C-6) are examples of the above polymerizable monomer. However, the radical polymerizable monomer need only have the above-stated absorption characteristics, and is not limited to general formulas (C-1) to (C-6) below.

(C-1) 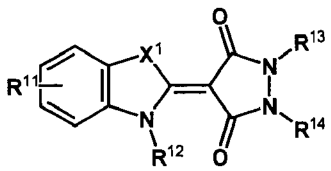

(C-2) 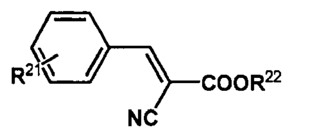

(C-3) 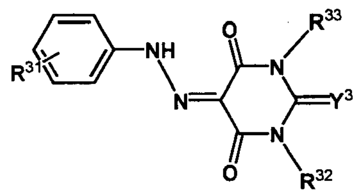

(C-4) 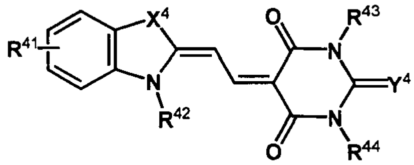

(C-5)

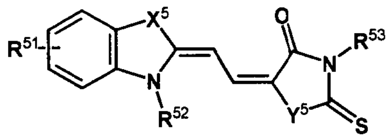

(C-6)

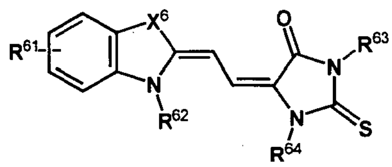

General formulas (C-1) to (C-6) will be described in detail below.
In the formulas, $R^{11}$, $R^{21}$, $R^{31}$, $R^{41}$, $R^{51}$ and $R^{61}$ each independently denote a hydrogen atom, halogen atom, radical polymerizable group, optionally radical polymerizable group-substituted alkyl group, aryl group, heterocyclic group, alkoxy group, aryloxy group, alkoxycarbonyl group, aryloxycarbonyl group, carbamoyl group, sulfamoyl group, amino group, acyloxy group, acylamino group, hydroxyl group, carboxylic acid group, or sulfonic acid group. Of these, a hydrogen atom, halogen atom, optionally radical polymerizable group-substituted alkyl group, aryl group, heterocyclic group, alkoxy group, or aryloxy group is preferable; a hydrogen atom, halogen atom, optionally radical polymerizable group-substituted alkoxy group, aryloxy group, or amino group is more preferable; and a hydrogen atom or halogen atom is of greater preference. The above substituents denoted by $R^{11}$, $R^{21}$, $R^{31}$ $R^{41}$, $R^{51}$, and $R^{61}$ may be further substituted.

$R^{12}$, $R^{13}$, $R^{14}$, $R^{22}$, $R^{32}$, $R^{33}$, $R^{42}$, $R^{43}$, $R^{44}$, $R^{52}$, $R^{53}$, $R^{62}$, $R^{63}$, and $R^{64}$ each independently denote a hydrogen atom, radical polymerizable group, optionally radical polymerizable group-substituted alkyl group, aryl group, or heterocyclic group. Of these, a hydrogen atom, optionally radical polymerizable group-substituted alkyl group, or aryl group is preferable; and a hydrogen atom or optionally radical polymerizable group-substituted alkyl group is more preferable. The above alkyl group, aryl group, or heterocyclic group may be further substituted.

The above alkyl group is preferably an alkyl group having 1 to 20 carbon atoms, more preferably an alkyl group having 1 to 15 carbon atoms, and further preferably, an alkyl group having 1 to 10 carbon atoms. Examples of such alkyl groups are: methyl groups, ethyl groups, normal propyl groups, isopropyl groups, normal butyl groups, isobutyl groups, tertiary butyl groups, pentyl groups, cyclopentyl groups, hexyl groups, cyclohexyl groups, heptyl groups, octyl groups, tertiary octyl groups, 2-ethylhexyl groups decyl groups, dodecyl groups, and octadecyl groups. These may be further substituted.

The above aryl group is preferably an aryl group having 6 to 14 carbon atoms, more preferably an aryl group having 6 to 10 carbon atoms, and further preferably an aryl group having 6 carbon atoms. Examples of such aryl groups are phenyl groups, naphthyl groups, and anthranyl groups. These may be further substituted.

The above heterocyclic group is preferably a heterocyclic group having 4 to 13 carbon atoms, more preferably a heterocyclic group having 4 to 10 carbon atoms, and further preferably, a heterocyclic group having 4 or 5 carbon atoms. Examples of such heterocyclic groups are pyridine groups, thiophene groups, pyrrole groups, pyrrolidine groups, imidazole groups oxazole groups, and thiazole groups. These may be further substituted.

Examples of the above halogen atom are iodine, bromine, chlorine, and fluorine atoms. Of these, iodine and bromine atoms are preferable.

The above alkoxy group is preferably an alkoxy group having 1 to 20 carbon atoms, more preferably an alkoxy group having 1 to 10 carbon atoms, and further preferably, an alkoxy group having 1 to 5 carbon atoms. Examples of such alkoxy groups are: methoxy groups, ethoxy groups, butoxy groups, propioxy groups, hexyloxy groups, cyclohexyloxy groups, heptyloxy groups, octyloxy groups, tertiary octyloxy groups, 2-ethylhexyloxy groups, decyloxy groups, dodecyloxy groups, and octadecyloxy groups. The alkoxy group may be further substituted.

The above aryloxy group is preferably an aryloxy group having 6 to 12 carbon atoms, more preferably an aryloxy group having 6 carbon atoms. Examples of such aryloxy groups are phenyloxy groups, naphthyloxy groups, and anthranyloxy groups. The aryloxy group may be further substituted.

The above alkoxycarbonyl group is preferably an alkoxycarbonyl group having 1 to 10 carbon atoms, more preferably an alkoxycarbonyl group having 1 to 7 carbon atoms, and further preferably, an alkoxycarbonyl group having 1 to 5 carbon atoms. Examples of such alkoxycarbonyl groups are methoxycarbonyl groups, ethoxycarbonyl groups, butoxycarbonyl groups, propioxycarbonyl groups, hexyloxycarbonyl groups, cyclohexyloxycarbonyl groups, heptyloxycarbonyl groups, octyloxycarbonyl groups, tertiary octyloxycarbonyl groups, and 2-ethylhexyloxycarbonyl groups. The alkyloxycarbonyl group may be further substituted.

The above aryloxycarbonyl group is preferably an aryloxycarbonyl group having 6 to 12 carbon atoms, more preferably an aryloxycarbonyl group having 6 carbon atoms. Examples of such aryloxycarbonyl groups are phenyloxycarbonyl groups, naphthyloxycarbonyl groups, and anthranyloxycarbonyl groups. The aryloxycarbonyl group may be further substituted.

The above carbamoyl group is preferably a carbamoyl group having 1 to 12 carbon atoms, more preferably a carbamoyl group having 1 to 6 carbon atoms. Examples of such carbamoyl groups are methylcarbamoyl groups, ethylcarbamoyl groups, normal propylcarbamoyl groups, isopropylcarbamoyl groups, normal butylcarbamoyl groups, isobutylcarbamoyl groups, tertiary butylcarbamoyl groups, and phenylcarbamoyl groups. The carbamoyl group may be further substituted.

The above sulfamoyl group is preferably a sulfamoyl group having 1 to 12 carbon atoms, more preferably a sulfamoyl group having 1 to 6 carbon atoms. Examples of such sulfamoyl groups are methylsulfamoyl groups, ethylsulfamoyl groups, normal propylsulfamoyl groups, isopropylsulfamoyl groups, normal butylsulfamoyl groups, isobutylsulfamoyl groups, tertiary butylsulfamoyl groups, and phenylsulfamoyl groups. The sulfamoyl group may be further substituted.

The above amino group is preferably an amino group having 1 to 12 carbon atoms, more preferably an amino group having 1 to 6 carbon atoms. The amino group may have one or two substituents. Examples of such amino groups are methylamino groups, dimethylamino groups, ethylamino groups, diethylamino groups, normal propylamino groups, isopropylamino groups, normal butylamino groups, isobutylamino groups, tertiary butylamino groups, phenylamino groups, and diphenylamino groups. The amino group may be further substituted.

The above acyloxy group is preferably an acyloxy group having 1 to 12 carbon atoms, more preferably an acyloxy group having 1 to 6 carbon atoms. Examples of such acyloxy groups are methylcarbonyloxy groups, ethylcarbonyloxy groups, normal propylcarbonyloxy groups, isopropylcarbonyloxy groups, normal butylcarbonyloxy groups, isobutylcarbonyloxy groups, tertiary butylcarbonyloxy groups, phenylcarbonyloxy groups, and acryloyloxy groups. The acyloxy group may be further substituted.

The above acylamino group is preferably an acylamino group having 1 to 12 carbon atoms, more preferably an acylamino group having 1 to 6 carbon atoms. Examples of such acylamino groups are methylcarbonylamino groups, ethylcarbonylamino groups, normal propylcarbonylamino groups, isopropylcarbonylamino groups, normal butylcarbonylamino groups, isobutylcarbonylamino groups, tertiary butylcarbonylamino groups, phenylcarbonylamino groups, and acryloylamino groups. The acylamino group may be further substituted.

Examples of substituents that can be substituted on the above groups are alkyl groups, phenyl groups, halogen atoms, alkoxy groups, aryloxy groups, alkoxycarbonyl groups, aryloxycarbonyl groups, acyloxy groups, acylamino groups, carbamoyl groups, sulfamoyl groups, cyano groups, carboxylic acid groups, hydroxyl groups, sulfonic acid groups, and heterocyclic rings. Of these substituents, phenyl groups, halogen atoms, alkoxy groups, aryloxy groups, alkoxycarbonyl groups, aryloxycarbonyl groups, acyloxy groups, acylamino groups, carbamoyl groups, cyano groups, and heterocyclic rings are preferable; halogen atoms, alkoxy groups, aryloxy groups, alkoxycarbonyl groups, acyloxy groups, and acylamino groups are more preferable; and phenyl groups, halogen atoms, alkoxy groups, aryloxy groups, and alkoxycarbonyl groups are of greater preference.

In general formula (C-1), at least one from among $R^{11}$ to $R^{14}$ comprises a radical polymerizable group; in general formula (C-2), at least one from among $R^{21}$ and $R^{22}$ comprises a radical polymerizable group; in general formula (C-3), at least one from among $R^{31}$ to $R^{33}$ comprises a radical polymerizable group; in general formula (C-4), at least one from among $R^{41}$ to $R^{44}$ comprises a radical polymerizable group; in general formula (C-5), at least one from among $R^{51}$ to $R^{53}$ comprises a radical polymerizable group; and in general formula (C-6), at least one from among $R^{61}$ to $R^{63}$ comprises a radical polymerizable group. The number of polymerizable groups contained in the above polymerizable monomer is not specifically limited, but is preferably 1.

General formulas (P-1) to (P-3) are examples of the above radical polymerizable group. However, the radical polymerizable group need only be a group capable of undergoing radical polymerization, and is not limited to (P-1) to (P-3) below.

(P-1)

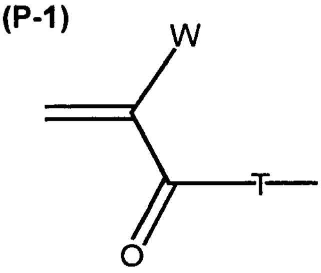

(P-2)

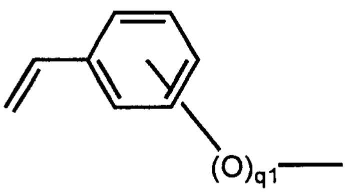

(P-3)

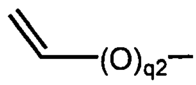

In (P-1) to (P-3), W denotes a hydrogen atom or methyl group; T denotes an oxygen atom or a divalent linking group denoted by $NR_8$, where $R_8$ denotes a hydrogen atom or alkyl group; and q 1 and q2 each independently denote 0 or 1.

There are preferably 1 to 5, more preferably 1 to 2, and further preferably, 1 carbon atom in the alkyl group denoted by $R_8$. Specific examples of the alkyl group denoted by $R_8$ are a methyl group and an ethyl group. These may

further comprise one or more substituents.

Examples of these substituents are alkyl groups, phenyl groups, halogen atoms, alkoxy groups, aryloxy groups, alkoxycarbonyl groups, acyloxy groups, acylamino groups, carbamoyl groups, cyano groups, carboxylic acid groups, sulfonic acid groups, sulfamoyl groups, sulfonamide groups, oxycarbonyl groups, and heterocyclic groups. Of these, alkoxy groups, acyloxy groups, and acylamino groups are preferred, and acyloxy groups and acylamino groups are of greater preference.

Of the polymerizable groups denoted by (P-1) to (P-3), the polymerizable groups denoted by general formulas (P-1) and (P-2) are preferable, and the polymerizable group denoted by general formula (P-1) is more preferable. Specifically, acryloyloxy groups, methacryloyloxy groups, N-acryloylamino groups, N-acryloyl-N-alkylamino groups and the like are preferable. When the above substituent denoted by $R^{11}$ and the like is the polymerizable group denoted by general formula (P-1), a polymer may be rapidly formed.

$X^1$, $X^4$, $X^5$ and $X^6$ each independently denote an oxygen atom, sulfur atom, selenium atom, or $CRa_2$, where Ra denotes a hydrogen atom or alkyl group (such as a methyl group).

$Y^3$ and $Y^4$ each independently denote an oxygen atom, sulfur atom, or selenium atom.

As the radical polymerizable monomer denoted by (C-1), those in which each of $R^{11}$, $R^{13}$, and $R^{14}$ independently denotes a hydrogen atom or alkyl group, $R^{12}$ denotes a radical polymerizable group-substituted alkyl group, and $X^1$ denotes an oxygen atom or a sulfur atom are preferable, and those in which $R^{11}$, $R^{13}$, and $R^{14}$ all denote hydrogen atoms, $R^{12}$ denotes a radical polymerizable group-substituted alkyl group, and $X^1$ denotes a sulfur atom are more preferable.

As the radical polymerizable monomer denoted by (C-2), those in which $R^{21}$ denotes a radical polymerizable group-substituted alkyl group and $R^{22}$ denotes an alkyl group or aryl group are preferable, and those in which $R^{21}$ denotes a radical polymerizable group-substituted alkyl group and $R^{22}$ denotes an alkyl group are more preferable.

As the radical polymerizable monomer denoted by (C-3), those in which each of $R^{31}$ $R^{32}$, and $R^{33}$ independently denotes alkyl groups, one of which being a radical polymerizable group-substituted alkyl group, and $Y^3$ denotes an oxygen atom or sulfur atom are preferable, and those in which each of $R^{31}$ and $R^{32}$ independently denotes an alkyl group, and $R^{33}$ denotes a radical polymerizable group-substituted alkyl group, and $Y^3$ denotes an oxygen atom are more preferable.

As the radical polymerizable monomer denoted by (C-4), those in which $R^{41}$ denotes a hydrogen atom or an alkyl group, each of $R^{42}$ and $R^{43}$ independently denotes an alkyl group, with one of the two denoting a radical polymerizable monomer-substituted alkyl group, $R^{44}$ denotes an alkyl group, $X^4$ denotes a sulfur atom, oxygen atom, or $C(Me)_2$, and $Y^4$ denotes a sulfur atom or oxygen atom are preferable, those in which $R^{41}$ denotes a hydrogen atom, each of $R^{42}$ and $R^{43}$ independently denotes an alkyl group, with one of the two being a radical polymerizable group-substituted alkyl group, $R^{44}$ denotes an alkyl group, $X^4$ denotes an oxygen atom or $C(Me)_2$, and $Y^4$ denotes a sulfur atom or oxygen atom are more preferable, and those in which $R^{41}$ denotes a hydrogen atom, $R^{42}$ denotes a radical polymerizable group-substituted alkyl group, each of $R^{43}$ and $R^{44}$ independently denotes an alkyl group, $X^4$ denotes $C(Me)_2$, and $Y^4$ denotes an oxygen atom are further preferable.

As the radical polymerizable monomer denoted by (C-5), those in which $R^{51}$ denotes a hydrogen atom or an alkyl group, $R^{52}$ denotes a radical polymerizable group-substituted alkyl group, $R^{53}$ denotes an alkyl group, $X^5$ denotes a sulfur atom, oxygen atom, or $C(Me)_2$, and $Y^5$ denotes an oxygen atom or sulfur atom are preferable, and those in which $R^{51}$ denotes a hydrogen atom, $R^{52}$ denotes a radical polymerizable group-substituted alkyl group, $R^{53}$ denotes an alkyl group, $X^5$ denotes an oxygen atom or $C(Me)_2$, and $Y^5$ denotes a sulfur atom are more preferable.

As the radical polymerizable monomer denoted by (C-6), those in which each of $R^{61}$, $R^{63}$, and $R^{64}$ independently denotes a hydrogen atom or alkyl group, $R^{62}$ denotes a radical polymerizable group-substituted alkyl group, and $X^6$ denotes a hydrogen atom or sulfur atom are preferable, and those in which each of $R^{61}$, $R^{63}$, and $R^{64}$ denotes a hydrogen atom, $R^{62}$ denotes a radical polymerizable group-substituted alkyl group, and $X^6$ denotes a sulfur atom are more preferable.

Among (C-1) to (C-6), (C-2), (C-4), (C-5), and (C-6) are preferable; (C-4) and (C-5) are more preferable; and (C-4) is of greater preference.

Specific examples of these radical polymerizable monomers will be given below. However, the present invention is not limited to the specific examples.

M-1
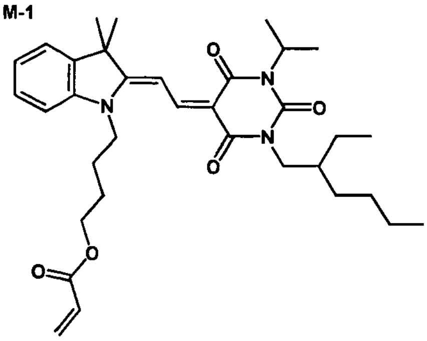

M-2
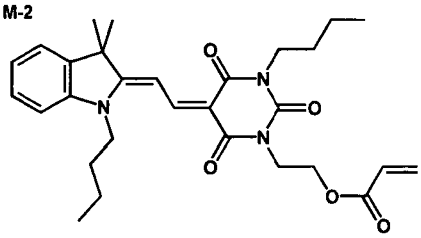

M-3
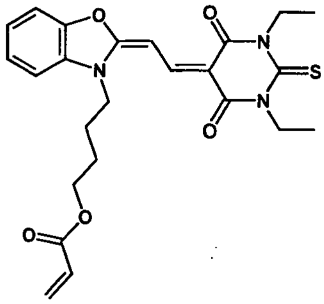

M-4
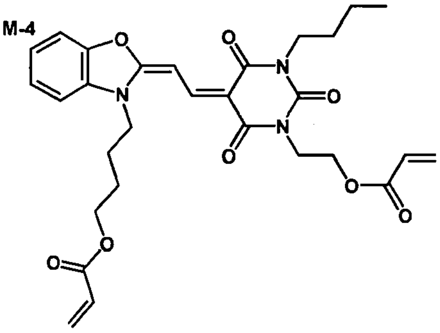

M-5
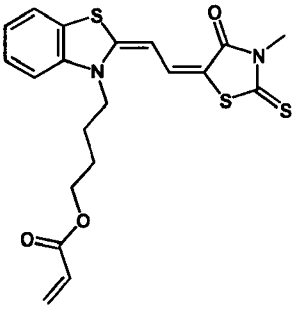

M-6
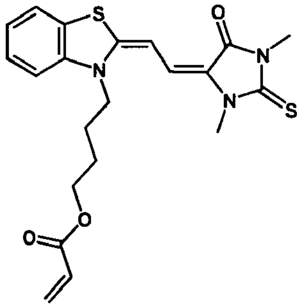

M-7
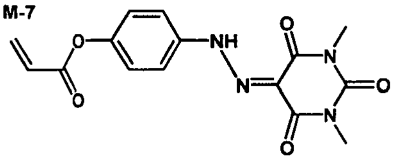

M-8
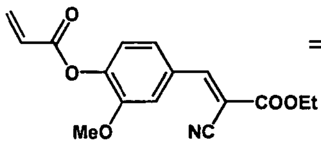

M-9
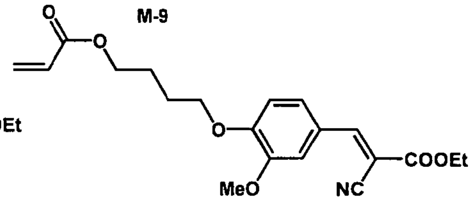

M-10
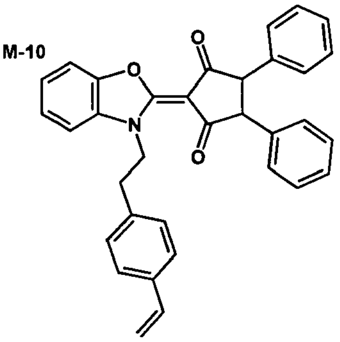

M-11
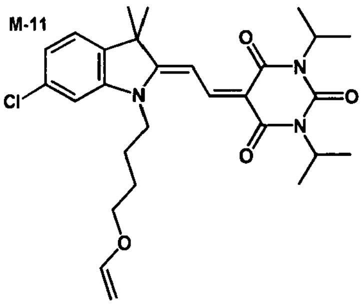

The method of synthesizing example compound M-1 in Examples described further below is an example of a method of synthesizing the radical polymerizable monomer. The other compounds can be synthesized by similar methods. However, the method of synthesizing the radical polymerizable monomer is not limited; the radical polymerizable monomer can be synthesized by suitably combining known methods.

The above-described polymerizable monomer can be employed alone as the recording material, or other polymerizable monomers may be employed in combination with it as needed. The polymerizable monomers that may be employed in combination are not specifically limited. They may be suitably selected based on the objective; examples are radical polymerizable monomers having unsaturated bonds, such as acrylic groups and methacrylic groups; or cationic polymerizable monomers having ether structures, such as epoxy rings or oxetane rings. These monomers may

be monofunctional or polyfunctional. Those undergoing a photocrosslinking reaction may also be employed.

Specific examples of monomers that can be employed in combination with the above radical polymerizable monomer are: acryloyl morpholine, phenoxyethyl acrylate, isobornyl acrylate, 2-hydroxypropyl acrylate, 2-ethylhexyl acrylate, 1,6-hexanediol diacrylate, tripropylene glycol diacrylate, neopentyl glycol PO-modified diacrylate, 1,9-nonanediol diacrylate, hydroxypivalic acid neopentyl glycol diacrylate, EO-modified bisphenol A diacrylate, polyethylene glycol diacrylate, di(urethane-acrylate)oligomer, pentaerythritol triacrylate, pentaerythritol tetraacrylate, pentaerythritol hexaacrylate, EO-modified glycerol triacrylate, trimethylolpropane triacrylate, EO-modified trimethylolpropane triacrylate, 2-naphtho-1-oxyethylacrylate, 2-carbazoyl-9-yl ethyl acrylate, (trimethylsilyloxy)dimethylsilylpropyl acrylate, vinyl-1-naphthoate, N-vinylcarbazole, 2,4,6-tribromophenyl acrylate, pentabromophenyl acrylate, phenylthioethyl acrylate, and tetrahydrofurfuryl acrylate.

These other polymerizable monomers may be employed singly or in combinations of two or more. The content in the optical recording composition of the present invention when employing another polymerizable monomer is preferably 1 to 40 weight percent, more preferably 1 to 20 weight percent, of the solid portion of the total polymerizable monomers.

Titanocene radical polymerization initiator

The optical recording composition of the present invention comprises a radical polymerization initiator in the form of a titanocene radical polymerization initiator. The fact that the use of a titanocene radical polymerization initiator with the above-described radical polymerizable monomer and urethane matrix-forming components (polyfunctional isocyanate and polyfunctional alcohol) described further below can enhance recording sensitivity and recording capacity as well as improve fixing property was discovered as a result of research conducted by the present inventor.

In holographic recording, the medium is usually subjected to a photodesensitization step (called fixing) to prevent the photoreaction from continuing due to irradiation by the light during reproduction and damaging the recorded information. The fixing step is preferably conducted at relatively low energy. The optical recording composition of the present invention can provide a holographic recording medium with good fixing property mentioned above.

The titanocene radical polymerization initiator is not specifically limited other than that it be sensitive to the recording light and induce a radical polymerization reaction when irradiated by the light; it can be suitably selected based on the objective. The titanocenes described in Japanese Unexamined Patent Publication (KOKAI) Showa No. 61-151197 or English language family member U.S. Patent No. 4,713,401 are preferable examples. They may be employed singly or in combinations of two or more.

The titanocene radical polymerization initiator denoted by general formula (I) below is an example of a preferable titanocene radical polymerization initiator.

General formula (I)

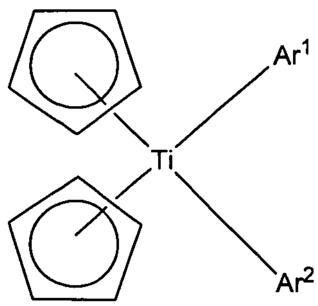

General formula (I) will be described below.

In general formula (I), $Ar^1$ and $Ar^2$ each independently denotes an optionally substituted aryl group. The aryl group is not specifically limited, and may be suitably selected based on the objective. An aryl group having 6 to 20 carbon atoms is preferable, an aryl group having 6 to 10 carbon atoms is more preferable, and an aryl group having 6 carbon atoms is of greater preference. Specific examples are phenyl groups, tolyl groups, naphthyl groups, and anthranyl groups. $Ar^1$ and $Ar^2$ may be identical or different; however, they are preferably identical.

The aryl group may be substituted. Examples of substituents that may be present on the aryl group are: alkyl groups, phenyl groups, amino groups, halogen atoms, alkoxy groups, aryloxy groups, alkoxycarbonyl groups, acyloxy groups, acrylamino groups, carbamoyl groups, cyano groups, and heterocyclic groups. Of these, halogen atoms and heterocyclic groups are preferable. Fluorine and bromine atoms are preferable as halogen atoms. Nitrogen-containing

aromatic heterocyclic groups are preferable as heterocyclic groups; a pyridine ring group is one specific example.

The titanocene radical polymerization initiator denoted by general formula (II) is preferable as the titanocene radical polymerization initiator denoted by general formula (I).

General formula (II)

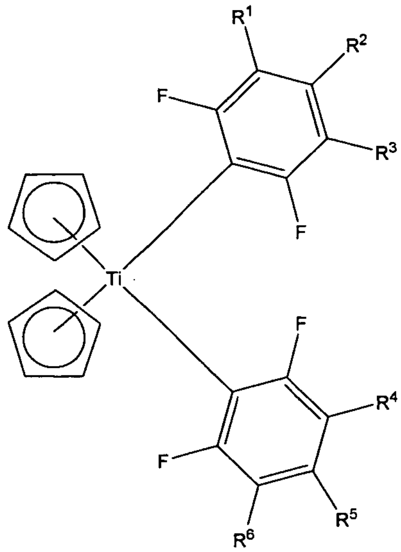

General formula (II) will be described below.

In general formula (II), $R^1$ to $R^6$ each independently denote a hydrogen atom, halogen atom, or heterocyclic group. The details of the halogen atoms and heterocyclic groups are as set forth above.

Preferable specific examples of the titanocene radical polymerization initiator denoted by general formula (II) will be given. However, the present invention is not limited to these specific examples. Among the specific examples given below, bis(η-5-2,4-cyclopentadien-1-yl) bis[2,6-difluoro-3-(1H-pyrrole-1-yl)]phenyltitanium is the example of greatest preference.

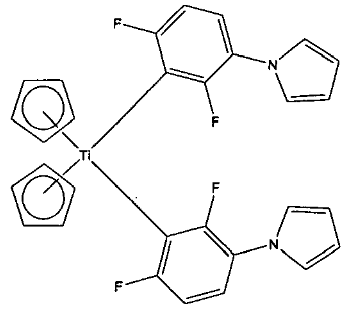

Bis(η-5-2,4-cyclopentadien-1-yl) bis[2,6-difluoro-3-(1H-pyrrole-1-yl)]phenyltitanium

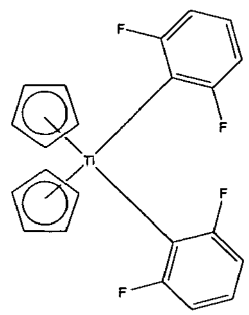

Bis(η-5-2,4-cyclopentadien-1-yl) bis(2,6-difluoro)phenyltitanium

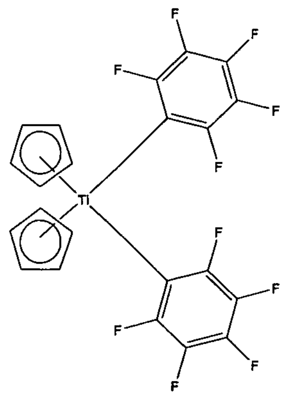

Bis(η-5-2,4-cyclopentadien-1-yl) bis(2,3,4,5,6-pentafluoro)phenyltitanium

The above-described titanocene radical polymerization initiator can be synthesized by the method described in Japanese Unexamined Patent Publication (KOKAI) Showa No. 61-151197 or English language family member U.S. Patent No. 4,713,401. Some of them are also available as a commercial product.

The quantity of titanocene radical polymerization initiator in the optical recording composition of the present invention is preferably 0.3 to 4 weight percent, more preferably 0.5 to 3 weight percent, of the total solid portion of the optical recording composition.

A sensitizing agent may be added to the optical recording composition of the present invention based on the wavelength of the light irradiated. Known compounds such as those described in "Research Disclosure, Vol. 200, 1980, December, Item 20036" and "Sensitizers" (pp. 160-163, Kodansha, ed. by K. Tokumaru and M. Okawara, 1987) and the like may be employed as sensitizing dyes.

Specific examples of sensitizing dyes are: 3-ketocoumarin compounds described in Japanese Unexamined Patent Publication (KOKAI) Showa No. 58-15603; thiopyrilium salt described in Japanese Unexamined Patent Publication (KOKAI) Showa No. 58-40302; naphthothiazole merocyanine compounds described in Japanese Examined Patent Publications (KOKOKU) Showa Nos. 59-28328 and 60-53300; and merocyanine compounds described in Japanese Examined Patent Publications (KOKOKU) Showa Nos. 61-9621 and 62-3842 and Japanese Unexamined Patent Publications (KOKAI) Showa Nos. 59-89303 and 60-60104.

Further examples are the dyes described in "The Chemistry of Functional Dyes" (1981, CMC Press, pp. 393-416) and "Coloring Materials" (60 [4] 212-224 (1987)). Specific examples are cationic methine dyes, cationic carbonium dyes, cationic quinoneimine dyes, cationic indoline dyes, and cationic styryl dyes.

Further, keto dyes such as coumarin (including ketocoumarin and sulfonocoumarin) dyes, merostyryl dyes, oxonol dyes, and hemioxonol dyes; nonketo dyes such as nonketo polymethine dyes, triarylmethane dyes, xanthene dyes, anthracene dyes, rhodamine dyes, acrylidine dyes, aniline dyes, and azo dyes; nonketo polymethine dyes such as azomethine dyes, cyanine dyes, carbocyanine dyes, dicarbocyanine dyes, tricarbocyanine dyes, hemicyanine dyes, and styryl dyes; and quinone imine dyes such as azine dyes, oxazine dyes, thiazine dyes, quinoline dyes, and thiazole dyes are included among the spectral sensitizing dyes. These sensitizing dyes may be employed singly or in combinations of two or more. These sensitizing agents may bind to a portion of the binder.

The quantity of the sensitizing dye in the optical recording composition of the present invention is preferably 0.3 to 4

weight percent, more preferably 0.5 to 3 weight percent, of the total solid portion of the optical recording composition.

Polyurethane binder

The optical recording composition normally comprises a polymer (referred to as a binder or matrix) for holding the polymerization initiator and monomers relating to the recording and storage of information. The optical recording composition of the present invention comprises a polyfunctional isocyanate and polyfunctional alcohol as components for forming a binder for holding the above-described titanocene radical polymerization initiator and radical polymerizable monomers. The binder (polyurethane binder) formed with the above-stated components can serve to enhance coating properties, coating strength, and the refractive index difference and sensitivity in holographic recording. In the present invention, the term "polyfunctional" means bifunctional or greater.
The above polyfunctional isocyanate and polyfunctional alcohol will be described below.

- Polyfunctional isocyanate-

Examples of the polyfunctional isocyanates are: biscyclohexylmethane diisocyanate, hexamethylene diisocyanate, phenylene-1,3-diisocyanate, phenylene-1,4-diisocyanate, 1-methoxyphenylene-2,4-diisocyanate, 1-methylphenylene-2,4-diisocyanate, 2,4-tolylene diisocyanate, 2,6-tolylene diisocyanate, 1,3-xylylene diisocyanate, 1,4-xylylene diisocyanate, biphenylene-4,4'-diisocyanate, 3,3'-dimethoxybiphenylene-4,4'-diisocyanate, 3,3'-dimethylbiphenylene-4,4'-diisocyanate, diphenylmethane-2,4'-diisocyanate, diphenylmethane-4,4'-diisocyanate, 3,3'-dimethoxydiphenylmethane-4,4'-diisocyanate, 3,3'-dimethyldiphenylmethane-4,4'-diisocyanate, naphthylene-1,5-diisocyanate, cyclobutylene-1,3-diisocyanate, cyclopentylene-1,3-diisocyanate, cyclohexylene-1,3-diisocyanate, cyclohexylene-1,4-diisocyanate, 1-methylcyclohexylene-2,4-diisocyanate, 1-methylcyclohexylene-2,6-diisocyanate, 1-isocyanate-3,3,5-trimethyl-5-isocyanate methylcyclohexane, cyclohexane-1,3-bis(methylisocyanate), cyclohexane-1,4-bis(methylisocyanate), isophorone diisocyanate, dicyclohexylmethane-2,4'-diisocyanate, dicyclohexylmethane-4,4'-diisocyanate, ethylene diisocyanate, tetramethylene-1,4-diisocyanate, hexamethylene-1,6-diisocyanate, dodecamethylene-1,12-diisocyanate, phenyl-1,3,5-triisocyanate, diphenylmethane-2,4,4'-triisocyanate, diphenylmethane-2,5,4'-triisocyanate, triphenylmethane-2,4',4''-triisocyanate, triphenylmethane-4,4',4''-triisocyanate, diphenylmethane-2,4,2',4'-tetraisocyanate, diphenylmethane-2,5,2',5'-tetraisocyanate, cyclohexane-1,3,5-triisocyanate, cyclohexane-1,3,5-tris(methylisocyanate), 3,5-dimethylcyclohexane-1,3,5-tris(methylisocyanate), 1,3,5-trimethylcyclohexane-1,3,5-tris(methylisocyanate), dicyclohexylmethane-2,4,2'-triisocyanate, dicyclohexylmethane-2,4,4'-triisocyanate lysine isocyanate methyl ester, and prepolymers having isocyanates on both ends obtained by reacting a stoichiometrically excess quantity of one or more of these organic isocyanate compounds with a polyfunctional active hydrogen-containing compound. Of these, biscyclohexylmethane diisocyanate and hexamethylene diisocyanate are preferred. They may be employed singly or in combinations of two or more.

- Polyfunctional alcohol-

The above polyfunctional alcohols may be in the form of a single polyfunctional alcohol, or in the form of a mixture with other polyfunctional alcohols. Examples of these polyfunctional alcohols are: glycols such as ethylene glycol, triethylene glycol, diethylene glycol, polyethylene glycol, propylene glycol, polypropylene glycol, and neopentyl glycol; diols such as butanediol, pentanediol, hexanediol, heptanediol, and tetramethylene glycol; bisphenols; compounds in the form of these polyfunctional alcohols modified by polyethyleneoxy chains or polypropyleneoxy chains; and compounds in the form of these polyfunctional alcohols modified by polyethyleneoxy chains or polypropyleneoxy chains, such as glycerin, trimethylolpropane, butanetriol, pentanetriol, hexanetriol, decanetriol, and other triols.

The content of the above binder-forming components in the optical recording composition of the present invention is preferably 50 to 97 weight percent, more preferably 70 to 95 weight percent, of the solid component. When the content is equal to or greater than 50 weight percent, it is possible to achieve good recording characteristics. At equal to or less than 97 weight percent, good sensitivity can be achieved. The mixing ratio of the polyfunctional alcohol and polyfunctional isocyanate in the optical recording composition of the present invention is not specifically limited. However, from the perspective of curing, the molar ratio of hydroxyl groups is preferably close to that of isocyanate groups. The molar ratio of hydroxyl groups to isocyanate groups of 4:3 to 3:4 is preferable, 6:5 to 5:6 is more preferable, and 1:1 is of greater preference.

The optical recording composition of the present invention is, for example, coated on a substrate and then left standing at high temperature to allow a curing (polymerization) reaction to progress between the polyfunctional isocyanate and the polyfunctional alcohol, forming a polyurethane binder. The polyurethane binder-forming components can be cured with heat or cured using a catalyst or the like. Examples of catalysts that can be employed for the polymerization reaction are tin catalysts, nitrogen-containing hetero rings, and amines. The quantity of catalyst employed can be suitably

determined.
Examples of the above tin catalyst are: dimethyl tin dilaurate, dibutyl tin dilactate, and stannous octanoate.
Examples of the above nitrogen-containing hetero ring are: imidazole, pyridine, and pyrazole.
Examples of the above amine are: triethylamine, trioctylamine, and N-methylmorpholine.

-Other components-

Polymerization inhibitors and oxidation inhibitors may be added to the optical recording composition of the present invention to improve the storage stability of the optical recording composition, as needed.
The polymerization inhibitors and oxidation inhibitors are not specifically limited and can be suitably selected based on the objective. Examples of polymerization inhibitors and oxidation inhibitors are: hydroquinone, p-benzoquinone, hydroquinone monomethyl ether, 2,6-ditert-butyl-p-cresol, 2,2'-methylenebis(4-methyl-6-tert-butylphenol), triphenylphosphite, trisnonylphenylphoshite, phenothiazine, and N-isopropyl-N'-phenyl-p-phenylenediamine. Of these, 2,6-ditert-butyl-p-cresol and 2,2'-methylenebis(4-methyl-6-tert-butylphenol) are preferable. These may be used singly or in combinations of two or more.
The quantity of polymerization inhibitor or oxidation inhibitor added is preferably equal to or less than 3 weight percent of the total quantity of recording monomer. When the quantity added exceeds 3 weight percent, polymerization may slow down, and in extreme cases, ceases.
A photo-heat converting material can be incorporated into the optical recording composition of the present invention for enhancing the sensitivity of the recording layer formed with the optical recording composition.
The photo-heat converting material is not specifically limited, and may be suitably selected based on the functions and properties desired. For example, for convenience during addition to the recording layer with the recording monomer and so as not to scatter incident light, an organic dye or pigment is desirable. From the perspectives of not absorbing and not scattering light from the light source employed in recording, infrared radiation-absorbing dyes are desirable.
Such infrared radiation-absorbing dyes are not specifically limited, and may be suitably selected based on the objective. However, cationic dyes, complex-forming dyes, quinone-based neutral dyes, and the like are suitable. The maximum absorption wavelength of the infrared radiation-absorbing dye preferably falls within a range of 600 to 1,000 nm, more preferably a range of 700 to 900 nm.
The content of infrared radiation-absorbing dye in the optical recording composition of the present invention can be determined based on the absorbance at the wavelength of maximum absorbance in the infrared region in the recording medium formed with the optical recording composition of the present invention. This absorbance preferably falls within a range of 0.1 to 2.5, more preferably a range of 0.2 to 2.0.
Further, the optical recording composition of the present invention may comprise a component that can diffuse into the inverse direction with that of the polymerizable components in order to reduce the volume change at polymerization, or a compound having an acid cleavage configuration may be added to the holographic recording composition in addition to the polymers.
The optical recording composition of the present invention can be employed as various holographic recording compositions capable of recording information when irradiated with a light containing information. In particular, it is suited to use as a volume holographic recording composition.
The recording layer can be formed by casting when the viscosity of the optical recording composition is adequately low. When the viscosity is so high that casting is difficult, a dispenser can be employed to spread a recording layer on a lower substrate, and an upper substrate pressed onto the recording layer so as to cover it and spread it over the entire surface, thereby forming a recording medium.

HOLOGRAPHIC RECORDING MEDIUM

The holographic recording medium of the present invention comprises a recording layer formed with the optical recording composition of the present invention. For example, the recording layer comprised of the optical recording composition of the present invention can be formed by the above-described method.
The holographic recording medium of the present invention comprises the above recording layer (holographic recording layer), and preferably comprises a lower substrate, a filter layer, a holographic recording layer, and an upper substrate. As needed, it may comprise additional layers such as a reflective layer, filter layer, first gap layer, and second gap layer.
The holographic recording medium of the present invention is capable of recording and reproducing information through utilization of the principle of the hologram. This may be a relatively thin planar hologram that records two-dimensional information or the like, or a volumetric hologram that records large quantities of information, such as three-dimensional images. It may be either of the transmitting or reflecting type. Since the holographic recording medium of the present invention is capable of recording high volumes of information, it is suitable for use as a volume holographic

recording medium of which high recording density is demanded.

The method of recording a hologram on the holographic recording medium of the present invention is not specifically limited; examples are amplitude holograms, phase holograms, blazed holograms, and complex amplitude holograms. Among these, a preferred method is the so-called "collinear method" in which recording of information in volume holographic recording regions is carried out by irradiating an informing light and a reference light onto a volume holographic recording area as coaxial beams to record information by means of interference pattern through interference of the informing light and the reference light.

Details of substrates and various layers that can be incorporated into the holographic recording medium of the present invention will be described below.

- Substrate -

The substrate is not specifically limited in terms of its shape, structure, size, or the like; these may be suitably selected based on the objective. For example, the substrate may be disk-shaped, card-shaped, or the like. A substrate of a material capable of ensuring the mechanical strength of the holographic recording medium can be suitably selected. When the light employed for recording and reproducing enters after passing through the substrate, a substrate that is adequately transparent at the wavelength region of the light employed is desirable.

Normally, glass, ceramic, resin, or the like is employed as the substrate material. From the perspectives of moldability and cost, resin is particularly suitable. Examples of such resins are: polycarbonate resin, acrylic resin, epoxy resin, polystyrene resin, acrylonitrile - styrene copolymers, polyethylene resin, polypropylene resin, silicone resin, fluorine resin, ABS resin, and urethane resin. Of these, from the perspective of moldability, optical characteristics, and cost, polycarbonate resin and acrylic resin are preferred. Synthesized resins and commercially available resins may both be employed as substrates.

Normally, address servo areas are provided on the substrate at prescribed angular intervals as multiple positioning areas extending linearly in a radial direction, with the fan-shaped intervals between adjacent address servo areas serving as data areas. Information for operating focus servos and tracking servos by the sampled servo method, as well as address information, is recorded (preformatted) as pre-embossed pits (servo pits) or the like in address servo areas. Focus servo operation can be conducted using the reflective surface of a reflective film. Wobble pits, for example, can be employed as information for operating a tracking servo. When the holographic recording medium is card-shaped, it is possible not to have a servo pit pattern.

The thickness of the substrate is not specifically limited, and may be suitably selected based on the objective: a thickness of 0.1 to 5 mm is preferable, with 0.3 to 2 mm being preferred. A substrate thickness of equal to or greater than 0.1 mm is capable of preventing shape deformation during disk storage, while a thickness of equal to or less than 5 mm can avoid an overall disk weight generating an excessive load on the drive motor.

- Recording Layer -

The recording layer can be formed with the optical recording composition of the present invention and is capable of recording information by holography. The thickness of the recording layer is not specifically limited, and may be suitably selected based on the objective. A recording layer thickness falling within a range of 1 to 1,000 micrometers yields an adequate S/N ratio even when conducting 10 to 300 shift multiplexing, and a thickness falling within a range of 100 to 700 micrometers is advantageous in that it yields a markedly good S/N ratio.

Reflective Film -

A reflective film can be formed on the servo pit pattern surface of the substrate.
A material having high reflectance for the informing light and reference light is preferably employed as the material of the reflective film. When the wavelength of the light employed as the informing light and reference light ranges from 400 to 780 nm, examples of desirable materials are Al, Al alloys, Ag, and Ag alloys. When the wavelength of the light employed as the informing light and reference light is equal to or greater than 650 nm, examples of desirable materials are Al, Al alloys, Ag, Ag alloys, Au, Cu alloys, and TiN.
By employing an optical recording medium that reflects light as well as can be recorded and/or erased information such as a DVD (digital video disk) as a reflective film, it is possible to record and rewrite directory information, such as the areas in which holograms have been recorded, when rewriting was conducted, and the areas in which errors are present and for which alternate processing has been conducted, without affecting the hologram.

The method of forming the reflective film is not specifically limited and may be suitably selected based on the objective. Various vapor phase growth methods such as vacuum deposition, sputtering, plasma CVD, optical CVD, ion plating, and electron beam vapor deposition may be employed. Of these, sputtering is superior from the perspectives

of mass production, film quality, and the like.
The thickness of the reflective film is preferably equal to or greater than 50 nm, more preferably equal to or greater than 100 nm, to obtain adequate reflectance.

- Filter Layer -

A filter layer can be provided on the servo pits of the substrate, on the reflective layer, or on the first gap layer, described further below.
The filter layer has a function of reflecting selective wavelengths in which, among multiple light rays, only light of a specific wavelength is selectively reflected, permitting passing one light and reflecting a second light. It also has a function of preventing generation of noise in which irregular reflection of the informing light and the reference light by the reflective film of the recording medium is prevented without a shift in the selectively reflected wavelength even when the angle of incidence varies. Therefore, by stacking filter layers on the recording medium, it is possible to perform optical recording with high resolution and good diffraction efficiency.
The filter layer is not specifically limited and may be suitably selected based on the objective. For example, the filter layer can be comprised of a laminate in which at least one of a dichroic mirror layer, coloring material-containing layer, dielectric vapor deposition layer, single-layer or two- or more layer cholesteric layer and other layers suitably selected as needed is laminated. The thickness of the filter layer is not specifically limited and may be, for example, about 0.5 to 20 micrometers.
The filter layer may be laminated by direct application on the substrate or the like with the recording layer, or may be laminated on a base material such as a film to prepare a filter layer which is then laminated on the substrate.

- First Gap Layer -

The first gap layer is formed as needed between the filter layer and the reflective film to flatten the surface of the lower substrate. It is also effective for adjusting the size of the hologram that is formed in the recording layer. That is, since the recording layer should form a certain size of the interference region of the recording-use reference light and the informing light, it is effective to provide a gap between the recording layer and the servo pit pattern.
For example, the first gap layer can be formed by applying a material such as an ultraviolet radiation-curing resin from above the servo pit pattern and curing it. When employing a filter layer formed by application on a transparent base material, the transparent base material can serve as the first gap layer.
The thickness of the first gap layer is not specifically limited, and can be suitably selected based on the objective. A thickness of 1 to 200 micrometers is desirable.

- Second Gap Layer -

The second gap layer is provided as needed between the recording layer and the filter layer.
The material of the second gap layer is not specifically limited, and may be suitably selected based on the objective. Examples are: transparent resin films such as triacetyl cellulose (TAC), polycarbonate (PC), polyethylene terephthalate (PET), polystyrene (PS), polysulfone (PSF), polyvinylalcohol (PVA), and poly(methyl methacrylate) (PMMA); and norbornene resin films such as a product called ARTON film made by JSR Corporation and a product called Zeonoa made by Japan Zeon Co. Of these, those that are highly isotropic are desirable, with TAC, PC, the product called ARTON, and the product called Zeonoa being preferred.
The thickness of the second gap layer is not specifically limited and may be suitably selected based on the objective. A thickness of 1 to 200 micrometers is desirable.
Specific embodiments of the holographic recording medium of the present invention will be described in greater detail below. However, the present invention is not limited to these specific embodiments.

<First implementation embodiment>

Fig. 1 is a schematic cross-sectional view of the configuration of the holographic recording medium according to the first implementation embodiment. In holographic recording medium 21 according to the first implementation embodiment, a servo pit pattern 3 is formed on substrate 1 made of polycarbonate resin or glass, and aluminum, gold, platinum, or the like is coated on servo pit pattern 3 to provide reflective film 2. In Fig. 1, servo pit pattern 3 has been formed over the entire surface of lower substrate 1, but the servo pit pattern may be formed cyclically. Servo pit pattern 3 is normally 1,750 Angstroms (175 nm) in height, and is quite small relative to the thickness of the substrate and the other layers.
First gap layer 8 is formed by spin coating or the like a material such as an ultraviolet radiation-curing resin on

reflective film 2 of lower substrate 1. First gap layer 8 is effective for both the protection of reflective layer 2 and the adjustment of the size of the hologram formed in recording layer 4. That is, providing a gap between recording layer 4 and servo pit pattern 3 is effective for the formation of an interference area for the recording-use reference light and informing light of a certain size in recording layer 4.

Filter layer 6 is provided on first gap layer 8. Recording layer 4 is sandwiched between filter layer 6 and upper substrate 5 (a polycarbonate resin substrate or glass substrate) to form holographic recording medium 21.

Fig. 1 shows a filter layer 6 that passes only infrared radiation and blocks light of all other colors. Accordingly, since the informing light and recording and reproducing-use reference light are blue, they are blocked by filter layer 6 and do not reach reflective film 2. They return, exiting from entry and exit surface A.

Filter layer 6 is a multilayered vapor deposition film comprised of high refractive index layers and low refractive index layers deposited in alternating fashion.

Filter layer 6, comprised of a multilayered vapor deposition film, may be formed directly on first gap layer 8 by vacuum vapor deposition, or a film comprised of a multilayered vapor deposition film formed on a base material may be punched into the shape of a holographic recording medium to employed as filter layer 6.

In this embodiment, holographic recording medium 21 may be disk-shaped or card-shaped. When card-shaped, the servo pit pattern may be absent. In holographic recording medium 21, the lower substrate is 0.6 mm, first gap layer 8 is 100 micrometers, filter layer 6 is 2 to 3 micrometers, recording layer 4 is 0.6 mm, and upper substrate 5 is 0.6 mm in thickness, for a total thickness of about 1.9 mm.

An optical system applicable for the recording of information on and the reproduction of information from holographic recording medium 21 will be described with reference to Fig. 3.

First, a light (red light) emitted by a servo laser is nearly 100 percent reflected by dichroic mirror 13, passing through objective lens 12. Objective lens 12 directs the servo light onto holographic recording medium 21 so that it focuses at a point on reflective film 2. That is, dichroic mirror 13 passes light of green and blue wavelengths while reflecting nearly 100 percent of red light. The servo light entering entry and exit surface A to which and from which the light enters and exits of holographic recording medium 21 passes through upper substrate 5, recording layer 4, filter layer 6, and first gap layer 8, is reflected by reflective layer 2, and passes back through first gap layer 8, filter layer 6, recording layer 4, and upper substrate 5, exiting entry and exit surface A. The returning light that exits passes through objective lens 12, is nearly 100 percent reflected by dichroic mirror 13, and the servo information is detected by a servo information detector (not shown in Fig. 3). The servo information that is detected is employed for focus servo, tracking servo, slide servo, and the like. When the hologram material included in recording layer 4 is not sensitive to red light, the servo light passes through recording layer 4 without affecting recording layer 4, even when the servo light is randomly reflected by reflective film 2. Since the light in the form of the servo light reflected by reflective film 2 is nearly 100 percent reflected by dichroic mirror 13, the servo light is not detected by a CMOS sensor or CCD 14 for reproduction image detection and thus does not constitute noise to the reproduction light.

The informing light and recording-use reference light generated by the recording/reproducing laser passes through polarizing plate 16 and is linearly polarized. It then passes through half mirror 17, becoming circularly polarized light at the point where it passes through 1/4 wavelength plate 15. The light then passes through dichroic mirror 13, and is directed by objective lens 12 onto holographic recording medium 21 so that the informing light and recording-use reference light form an interference pattern in recording layer 4. The informing light and recording-use reference light enter through entry and exit surface A, interfering with each other to form an interference pattern in recording layer 4. Subsequently, the informing light and recording-use reference light pass through recording layer 4, entering filter layer 6. However, they are reflected before reaching the bottom surface of filter layer 6, returning. That is, neither the informing light nor the recording-use reference light reaches reflective film 2. That is because filter layer 6 is a multilayered vapor deposition layer in which multiple high refractive index and low refractive index layers are alternatively laminated, and has the property of passing only red light.

<Second implementation embodiment>

Fig. 2 is a schematic cross-sectional view of the configuration of the holographic recording medium according to the second implementation embodiment. A servo pit pattern 3 is formed on substrate 1 made of polycarbonate resin or glass in the holographic recording medium 22 accoding to the second implementation embodiment. Reflective film 2 is provided by coating aluminum, gold, platinum, or the like on the surface of servo pit pattern 3. Servo pit pattern 3 is normally 1,750 Angstroms (175 nm) in height in the same manner as in the first implementation embodiment.

The configuration of the second implementation embodiment differs from that of the first implementation embodiment in that second gap layer 7 is provided between filter layer 6 and recording layer 4 in holographic recording medium 22 according to the second implementation embodiment. A point at which the informing light and reproduction light are focused is present in second gap layer 7. When this area is embedded in a photopolymer, excessive consumption of monomer occurs due to excess exposure, and multiplexing recording capability diminishes. Accordingly, it is effective

to provide a nonreactive transparent second gap layer.

Filter layer 6 in the form of a multilayered vapor deposition film comprised of multiple layers in which multiple high refractive index and low refractive index layers are alternately laminated is formed over first gap layer 8 once first gap layer 8 has been formed, and the same one as employed in the first implementation embodiment can be employed as filter layer 6 in the second implementation embodiment.

In holographic recording medium 22 of the second implementation embodiment, lower substrate 1 is 1.0 mm, first gap 8 is 100 micrometers, filter layer 6 is 3 to 5 micrometers, second gap layer 7 is 70 micrometers, recording layer 4 is 0.6 mm, and upper substrate 5 is 0.4 mm in thickness, for a total thickness of about 2.2 mm.

When recording or reproducing information, a red servo light and a green informing light and recording/reproducing reference light are directed onto holographic recording medium 22 of the second implementation embodiment having the configuration set forth above. The servo light enters through entry and exit surface A, passing through recording layer 4, second gap layer 7, filter layer 6, and first gap layer 8, and is reflected by reflective film 2, returning. The returning light then passes sequentially back through first gap layer 8, filter layer 6, second gap layer 7, recording layer 4, and upper substrate 5, exiting through entry and exit surface A. The returning light that exits is used for focus servo, tracking servo, and the like. When the hologram material included in recording layer 4 is not sensitive to red light, the servo light passes through recording layer 4 and is randomly reflected by reflective film 2 without affecting recording layer 4. The green informing light and the like enters through entry and exit surface A, passing through recording layer 4 and second gap layer 7, and is reflected by filter layer 6, returning. The returning light then passes sequentially back through second gap layer 7, recording layer 4, and upper substrate 5, exiting through entry and exit layer A. During reproduction, as well, the reproduction-use reference light and the reproduction light generated by irradiating the reproduction-use reference light onto recording layer 4 exit through entry and exit surface A without reaching reflective film 2. The optical action around holographic recording medium 22 (objective lens 12, filter layer 6, and detectors in the form of CMOS sensors or CCD 14 in Fig. 3) is identical to that in the first implementation embodiment and thus the description thereof is omitted.

METHOD OF RECORDING AND REPRODUCING INFORMATION

The present invention further relates to a method of recording and reproducing information in the holographic recording medium of the present invention. The method of recording and reproducing information of the present invention comprises irradiating the holographic recording medium of the present invention with an informing light and a reference light to form an interference image in the recording layer comprised in the holographic recording medium; and irradiating the holographic recording medium in which the interference image has been formed with a reproduction light. Irradiation of the informing light and reference light to the recording layer formed with the optical recording composition of the present invention can form an interference image in the recording layer. Next, normally, a fixing light is irradiated to the recording layer in which the interference image has been formed, thereby fixing the interference image. Subsequently, a reproduction light is irradiated to the holographic recording medium in which the interference image has been formed to reproduce the information.

A reproduction light (wavelength $\lambda_3$ nm) satisfying equation (1) below with a wavelength $\lambda_1$ at which a molar absorbance coefficient of equal to or greater than 5,000 mole-1-cm$^{-1}$ is exhibited by the radical polymerizable monomer forming the recording layer contained in the optical recording medium is preferably employed in the method of recording and reproducing information of the present invention.

$$(\lambda_3 - 100) \leq \lambda_1 < \lambda_3 \qquad (1)$$

The details of the relation between wavelength $\lambda_1$ and the reproduction light wavelength are as set forth above. Further, as described above, the use of a reproduction light having a wavelength $\lambda_2$ at which the molar absorbance coefficient of the radical polymerizable monomer is equal to or lower than 100 mole·1·cm$^{-1}$ (preferably equal to or lower than 10 mole·1·cm$^{-1}$ and more preferably 0 mole·1·cm$^{-1}$) is preferred.

Normally, the absorption characteristics of the recording monomer depend primarily on main structural portions other than polymerizable groups. Thus, so long as no peculiar assembly is created, the absorption characteristics do not change greatly before and after the recording reaction. Thus, good recording and reproduction characteristics can be achieved by selecting the reproduction light based on the absorption characteristics of the recording monomer prior to the recording reaction, as set forth above.

The method of recording and reproducing information of the present invention will be described in detail below.

A light having coherent properties can be employed as the informing light. By irradiating the informing light and reference light onto the recording medium so that the optical axes of the informing light and reference light are coaxial,

it is possible to record in the recording layer an interference image generated by interference of the informing light and reference light. Specifically, a informing light imparted with a two dimensional intensity distribution and a reference light of intensity nearly identical to that of the informing light are superposed in the recording layer and the interference pattern that they form is used to generate an optical characteristic distribution in the recording layer, thereby recording information. The wavelengths of the informing light and reference light are preferably equal to or greater than 400 nm, more preferably 400 to 2,000 nm, and further preferably, 400 to 700 nm.

After recording information (forming an interference image) by irradiating the informing light and reference light, a fixing light can be irradiated to fix the interference image. The wavelength of the fixing light is preferably less than 400 nm, more preferably equal to or greater than 100 nm but less than 400 nm, and further preferably, equal to or greater than 200 nm but less than 400 nm.

Information can be reproduced by irradiating a reference light onto an interference image formed by the above-described method. In the course of reading (reproducing) information that has been written, just a reference light is irradiated onto the recording layer with the same arrangement as during recording, causing a reproduction light having an intensity distribution corresponding to the optical characteristic distribution formed in the recording layer to exit the recording layer. The details of the reproduction light are as set forth above. A light of the same or longer wavelength than the light irradiated to record information is preferably employed, and a light of the same wavelength is more preferably employed, as the reproduction light.

An optical recording and reproducing device suited to use in the recording and reproducing of information in the holographic recording medium of the present invention will be described with reference to Fig. 4.
The optical recording and reproducing device 100 of Fig. 4 is equipped with spindle 81 on which is mounted holographic recording medium 20, spindle motor 82 rotating spindle 81, and spindle servo circuit 83 controlling spindle motor 82 so that it maintains holographic recording medium 20 at a prescribed rpm level.

Recording and reproducing device 100 is further equipped with pickup 31 for recording information by irradiating a informing light and a recording-use reference light onto holographic recording medium 20, and for reproducing information that has been recorded on holographic recording medium 20 by irradiating a reproducing-use reference light onto holographic recording medium 20 and detecting the reproduction light; and driving device 84 capable of moving pickup 31 radially with respect to holographic recording medium 20.

Optical recording and reproducing device 100 is equipped with detection circuit 85 for detecting focus error signal FE, tracking error signal TE, and reproduction signal RF based on the output signals of pickup 31; focus servo circuit 86 that operates a focus servo by driving an actuator in pickup 31 to move an objective lens (not shown in Fig. 4) in the direction of thickness of holographic recording medium 20 based on focus error signal FE detected by detection circuit 85; tracking servo circuit 87 that operates a tracking servo by driving an actuator in pickup 31 to move an objective lens in the radial direction of holographic recording medium 20 based on tracking error signal TE detected by detection circuit 85; and slide servo circuit 88 that operates a slide servo by controlling drive device 84 to move pickup 31 in the radial direction of holographic recording medium 20 based on instructions from a controller, described further below, and tracking error signal TE.

Optical recording and reproducing device 100 is further equipped with signal processing circuit 89 that decodes the output data of a CCD array or CMOS in pickup 31 to reproduce data recorded in the data areas of holographic recording medium 20, reproduces a base clock based on reproduction signal RF from detection circuit 85, and determines addresses; controller 90 that effects overall control of optical recording and reproducing device 100; and operation element 91 providing various instructions to controller 90. Controller 90 inputs the base clock and address information outputted by signal processing circuit 89 and controls pickup 31, spindle servo circuit 83, slide servo circuit 88, and the like. Spindle servo circuit 83 inputs the base clock that is outputted by signal processing circuit 89. Controller 90 comprises a central processing unit (CPU), read only memory (ROM), and random access memory (RAM). The functions of controller 90 can be realized by having the CPU that employs the RAM as a work area and execute programs stored in the ROM.

## EXAMPLES

The present invention will be described in detail below based on examples. However, the present invention is not limited to the examples.

- Synthesis of radical polymerizable monomer -

Synthesis of Example compound M-1
To compound 1 (7.9 g) was added compound 2 (14. 9 g) and the mixture was stirred for 2 hours at 150°C. After cooling the mixture to room temperature, 50 mL of acetonitrile was added, compound 3 (16.2 g) was added, and triethylamine (5 g) was added by drops. The mixture was stirred for 4 hours at room temperature, at which time 500 mL of ethyl acetate and 500 mL of water were added. The organic layer was extracted and concentrated. The residue obtained was subjected

to silica gel chromatography (hexane/ethyl acetate = 2/1) to isolate 14.6 g of the target compound (M-1) at a yield of 51 percent. The synthesis scheme is shown below.

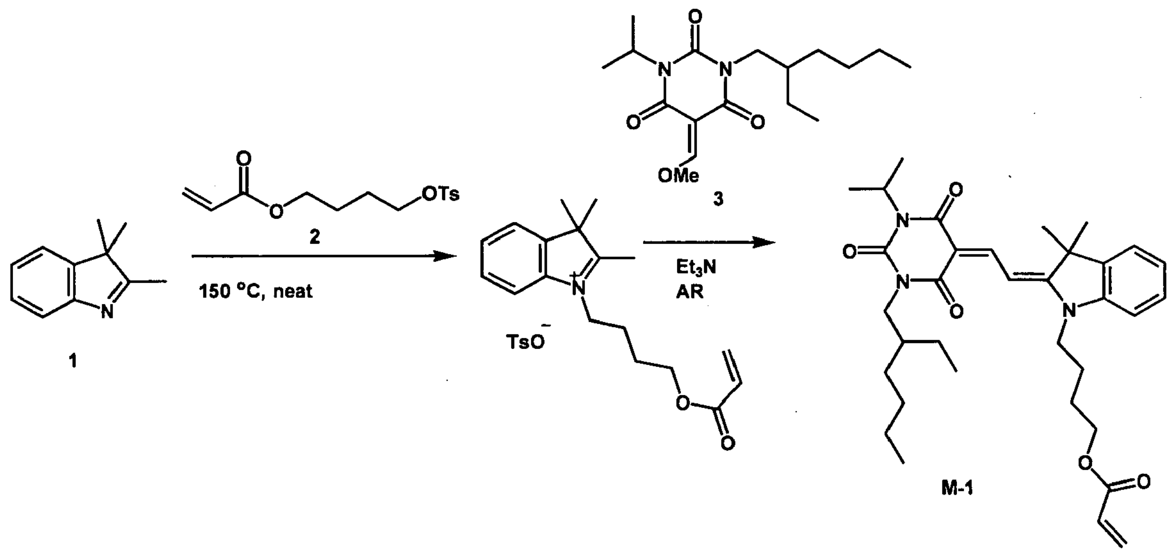


$^1$H-NMR was used to confirm that the target compound had been obtained. The identification results are given below.

$^1$H NMR (300 MHz, $CDCl_3$)δ0.82~0.95 (m, 6H), 1.21~1.42 (m, 5H), 1.49 (d, 6H), 1.76 (s, 6H), 1.82~2.02 (m, 4H), 3.82 (t, 2H), 4.07 (t, 2H), 4.21 (t, 2H), 5.19~5.30 (m ,1H), 5.81 (d, 1H), 6.07~6.19 (m, 1H), 6.39 (d, 1H), 6.99 (d, 1H), 7.18 (t, 1H), 7.28~7.38 (m, 2H), 7.77 (dd, 1H), 8.82 (d, 1H)

Example compounds M-3 and M-4 were synthesized according to the above method.

- Measurement of absorption characteristics -

Example compounds M-1, M-3, and M-4 were dissolved in methylene chloride to obtain solutions. A spectrophotometer for the ultraviolet and visible regions was used to measure the absorption spectra of the solutions, and the maximum absorption wavelength $\lambda_{max}$, molar absorbance coefficient at $\lambda_{max}$, and the molar absorbance coefficient at the reproduction light wavelength (532 nm) in medium evaluation, described further below, were obtained. The absorption characteristics of 2,4,6-tribromophenyl acrylate were similarly obtained. It was confirmed that 2,4,6-tribromophenyl acrylate did not have a wavelength at which the molar absorbance coefficient in the wavelength region ranging from 200 to 1,000 nm was 5,000 mole·1·cm$^{-1}$. The results are given in Table 1 below.

Table 1

| | $\lambda_{max}$ (nm) | Molar absorbance coefficient at $\lambda_{max}$ (mole·1·cm$^{-1}$) | Molar absorbance coefficient at the reproduction light wavelength (mole·1·cm$^{-1}$) |
|---|---|---|---|
| M-1 | 468.0 | 90,000 | 10 |
| M-3 | 458.0 | 110,000 | 31 |
| M-4 | 442.5 | 116,000 | 87 |
| 2,4,6-tribromophenyl acrylate | Equal to or less than 250 | - | 2 |

- Preparation of holographic recording composition -

Example 1

A composition of the following formula was mixed under a nitrogen gas flow to prepare the holographic recording composition of Example 1. The content (weight percent) of the various components of the composition below were based on the solid component.

- Biscyclohexylmethane diisocyanate 31.5 weight percent
- Polypropyleneoxidetriole (molecular weight 1,000) 61.2 weight percent
- Tetramethylene glycol 2.5 weight percent
- Example compound M-1 3.1 weight percent
- Photopolymerization initiator (bis(η-5-2,4-cyclopentadine-1-yl) bis[2,6-difluoro-3-(1H-pyrrole-1-yl)]phenyltitanium) Irgacure 784, made by Ciba Specialty Chemicals) 0.69 weight percent
- Dibutyl tin laurate 1.01 weight percent

Example 2

With the exception that Example compound M-3 was employed instead of Example compound M-1, a holographic recording composition was prepared in the same manner as in Example 1.

Example 3

With the exception that Example compound M-4 was employed instead of Example compound M-1, a holographic recording composition was prepared in the same manner as in Example 1.

Comparative Example 1

With the exception that 2,4,6-tribromophenyl acrylate was employed instead of Example compound M-1, a holographic recording composition was prepared in the same manner as in Example 1.

Comparative Example 2

A 0.3 g quantity of sensitizing dye in the form of DEAW, 1.2 g of radical polymerization initiator in the form of O-CL HABI, 1.8 g of the chain transfer agent MBO, 31.3 g of polymerizable monomer in the form of phenoxyethyl acrylate (made by Tokyo Chemical Industry Co., Ltd.), 50.4 g of cellulose butyl acrylate (CAB531-1 made by Eastman Chemicals) and 15.0 g of DM-2 were diluted in a three-fold quantity of methylene chloride. The absorption spectrum of the polymerizable monomer employed in Comparative Example 2 was measured with a spectrophotometer for the ultraviolet and visible regions and the fact that no wavelength existed that had a molar absorbance coefficient of equal to or greater than mole·1·$cm^{-1}$ within the wavelength region of 200 to 1,000 nm was confirmed.

DEAW
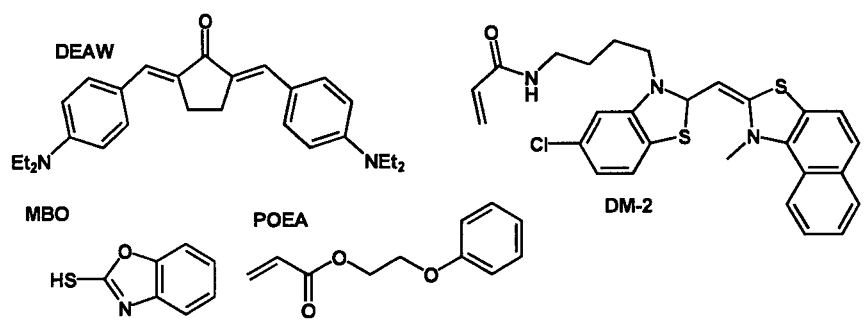
DM-2
MBO
POEA

- Preparation of Holographic Recording Medium-

Examples 4 to 6, Comparative Examples 3 and 4

A first substrate was prepared by subjecting one side of a glass sheet 0.5 mm in thickness to an antireflective treatment to impart a reflectance of 0.1 percent for perpendicularly incident light with the wavelength of 532 nm.
A second substrate was prepared by subjecting one side of a glass sheet 0.5 mm in thickness to an aluminum vapor deposition treatment to impart a reflectance of 90 percent for perpendicularly incident light with the wavelength of 532 nm.
A transparent polyethylene terephthalate sheet 500 micrometers in thickness was provided as a spacer on the side of the first substrate that had not been subjected to the antireflective treatment.
The holographic recording compositions of Examples 1 to 3 and Comparative Example 1 were each separately placed on first substrates, the aluminum vapor deposited surface of the second substrates were stacked on the optical recording composition in such a manner that air was not entrained, and the first and second substrates were bonded through the spacer. The holographic recording layer was left standing for 24 hours at 45°C to prepare the holographic recording media of Examples 1 to 3 and Comparative Example 3. The holographic recording layer formed was 200 micrometers in thickness.
In Comparative Example 4, the holographic recording composition of Comparative Example 2 was coated on a glass several times to 500 micrometers in thickness, and the other aluminum vapor deposited glass was stacked and bonded to prepare the holographic recording medium.

<Recording and evaluation of optical recording medium>

Employing a collinear hologram recording and reproduction tester (SHOT-1000, made by Pulsetec Industrial Co., Ltd.), a series of multiplexed holograms was written into the various optical recording media that had been prepared at a spot recording diameter of 200 micrometers at the focal position of the recording hologram, and the sensitivity (recording energy) and level of multiplexing were measured and evaluated as follows. The wavelengths of the informing light and reference light for recording were 532 nm, and the wavelength of the reproduction light was 532 nm.

- Sensitivity Measurement -

The beam energy during recording ($mJ/cm^2$) was varied and the change in the error rate (BER: bit error rate) of the reproduced signal was measured. Normally, there is such a tendency that the luminance of the reproduced signal increases and the BER of the reproduced signal gradually drops with an increase in the irradiated light energy. In the measurement, the lowest light energy at which a fairly good reproduced image (BER < $10^{-3}$) was obtained was adopted as the recording sensitivity of the holographic recording medium.

- Evaluation of the level of multiplexing -

The evaluation method whereby recorded spots are spirally shifted that is described in ISOM' 04, Th-J-06, pp. 184-185, Oct. 2004, was employed as a method of evaluating the level of multiplexing for each of the optical recording media obtained. The number of holograms recorded was 13 x 13 = 169 and the recording pitch was 28.5 micrometers. The multiplicity during the recording of the final (169th) hologram was 49. Since the multiplicity increased with the number of holograms recorded, an inadequate multiplexing property in the optical recording medium causes an increase in the BER as the number of recordings increased. The number of holograms recorded when BER > $10^{-3}$ was reached was adopted as the multiplexing characteristic M of the optical recording medium.

- Evaluation of the fixing property -

The various recording media obtained were irradiated at 532 nm through a band-pass filter of 532 nm (half band width 5 nm) with a xenon irradiating apparatus (made by Ushio) to an irradiation energy of 20,000 $mJ/cm^2$. The reflective transmittance before and after irradiation was measured based on a UV spectrum (UV-2000 made by Shimadzu Corporation). Denoting the initial transmittance at 532 nm as ε0 and that following irradiation as ε, the fixing property (A) was given by the following equation:

$$A = \varepsilon/\varepsilon 0 \times 100$$

The smaller this number, the better the fixing property.
The results of the above are given in Table 2 below.
Table 2

| | Optical recording composition | Recording sensitivity (mJ/cm$^2$) | Multiplexing characteristic M | Fixing property |
|---|---|---|---|---|
| Example 4 | Example 1 | 40 | 169 | 34 |
| Example 5 | Example 2 | 30 | 169 | 28 |
| Example 6 | Example 3 | 25 | 169 | 30 |
| Comp.Ex.1 | Comp.Ex.1 | 80 | 70 | 42 |
| Comp.Ex.2 | Comp.Ex.2 | 200 | 120 | 72 |

From the results in Table 2, it can be understood that the holographic recording media of Examples 4 to 6, in which the holographic recording compositions of Examples 1 to 3 were employed, all had good recording sensitivity, good multiplexing properties, and good fixing properties relative to the holographic recording media of Comparative Examples 3 and 4, in which the holographic recording compositions of Comparative Examples 1 and 2 were employed.
The holographic recording medium comprising a recording layer formed with the optical recording composition of the present invention permitted recording with high sensitivity and high density, and was thus suitable for use in various volume holographic optical recording media capable of high-density image recording.
Although the present invention has been described in considerable detail with regard to certain versions thereof, other versions are possible, and alterations, permutations and equivalents of the version shown will become apparent to those skilled in the art upon a reading of the specification and study of the drawings. Also, the various features of the versions herein can be combined in various ways to provide additional versions of the present invention. Furthermore, certain terminology has been used for the purposes of descriptive clarity, and not to limit the present invention. Therefore, any appended claims should not be limited to the description of the preferred versions contained herein and should include all such alterations, permutations, and equivalents as fall within the true spirit and scope of the present invention.
Having now fully described this invention, it will be understood to those of ordinary skill in the art that the methods of the present invention can be carried out with a wide and equivalent range of conditions, formulations, and other parameters without departing from the scope of the invention or any embodiments thereof.
Unless otherwise stated, a reference to a compound or component includes the compound or component by itself, as well as in combination with other compounds or components, such as mixtures of compounds.
As used herein, the singular forms "a," "an," and "the" include the plural reference unless the context clearly dictates otherwise.
Additionally, the recitation of numerical ranges within this specification is considered to be a disclosure of all numerical values and ranges within that range. For example, if a range is from about 1 to about 50, it is deemed to include, for example, 1, 7, 34, 46.1, 23.7, or any other value or range within the range.

## Claims

**1.** An optical recording composition comprising:

a radical polymerizable monomer having a wavelength $\lambda_1$ nm within an absorption spectrum ranging from 200 to 1,000 nm, the radical polymerizable monomer exhibiting a molar absorbance coefficient of equal to or greater than 5,000 mole·1·cm$^{-1}$ at the wavelength $\lambda_1$ nm;
a titanocene radical polymerization initiator;
a polyfunctional isocyanate; and
a polyfunctional alcohol.

**2.** The optical recording composition according to claim 1, wherein the wavelength $\lambda_1$ is a maximum absorption wavelength of the radical polymerizable monomer.

**3.** The optical recording composition according to claim 1 or 2, wherein the radical polymerizable monomer exhibits a molar absorbance coefficient of equal to or smaller than 100 mole·1·$cm^{-1}$ at the wavelength $\lambda_2$ nm within an absorption spectrum ranging from 350 to 750 nm.

**4.** The optical recording composition according to any of claims 1 to 3, wherein the titanocene radical polymerization initiator is a titanocene radical polymerization initiator denoted by general formula (I).

General formula (I)

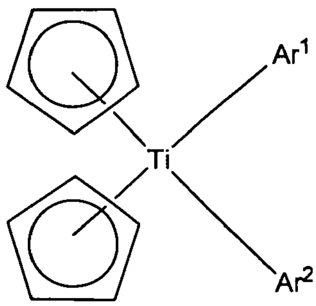

In general formula (I), $Ar^1$ and $Ar^2$ each independently denote an optionally substituted aryl group.

**5.** The optical recording composition according to claim 4, wherein the titanocene radical polymerization initiator denoted by general formula (I) is a titanocene radical polymerization initiator denoted by general formula (II).

General formula (II)

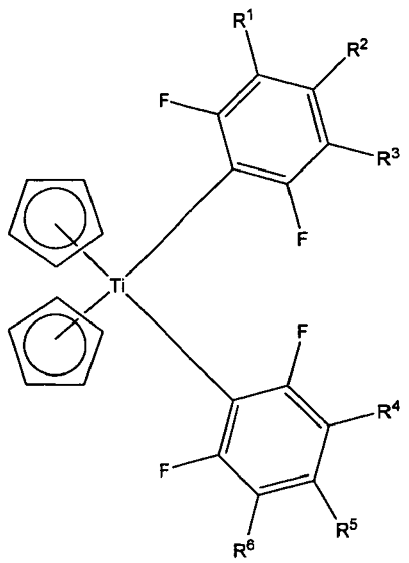

In general formula (II), $R^1$ to $R^6$ each independently denote a hydrogen atom, halogen atom, or heterocyclic group.

**6.** The optical recording composition according to any of claims 1 to 5, wherein the titanocene radical polymerization initiator is at least one selected from the group consisting of bis(η-5-2,4-cyclopentadien-1-yl) bis[2,6-difluoro-3-(1H-pyrrole-1-yl)]phenyltitanium, bis(η-5-2,4-cyclopentadien-1-yl) bis(2,6-difluoro)phenyltitanium, and bis(η-5-2,4-cyclopentadien-1-yl) bis(2,3,4,5,6-pentafluoro)phenyltitanium.

**7.** The optical recording composition according to any of claims 1 to 6, wherein the radical polymerizable monomer comprises at least one selected from the group consisting of radical polymerizable monomers denoted by general formulas (C-1), (C-2), (C-3), (C-4), (C-5) and (C-6).

(C-1)

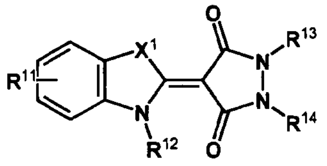

(C-2)

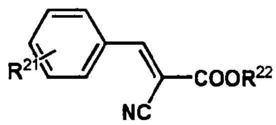

(C-3)

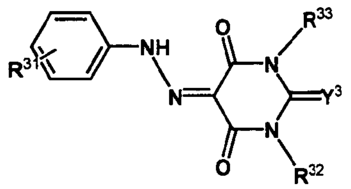

(C-4)

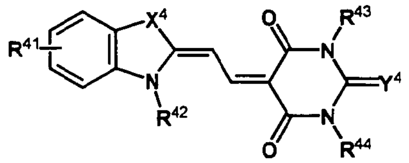

(C-5)

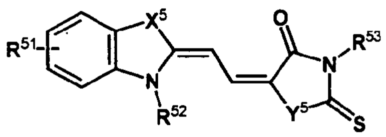

(C-6)

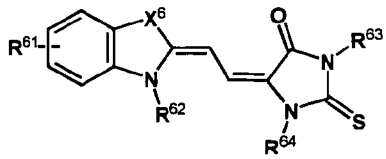

In the above formulas, $R^{11}$, $R^{21}$, $R^{31}$, $R^{41}$, $R^{51}$, and $R^{61}$ each independently denote a hydrogen atom, halogen atom, radical polymerizable group, optionally radical polymerizable group-substituted alkyl group, aryl group, heterocyclic group, alkoxy group, aryloxy group, alkoxycarbonyl group, aryloxycarbonyl group, carbamoyl group, sulfamoyl group, amino group, acyloxy group, acylamino group, hydroxyl group, carboxylic acid group, or sulfonic acid group; $R^{12}$, $R^{13}$ $R^{14}$ $R^{22}$ $R^{32}$, $R^{33}$, $R^{42}$, $R^{43}$, $R^{44}$, $R^{52}$, $R^{53}$, $R^{62}$, $R^{63}$, and $R^{64}$ each independently denote a hydrogen atom, radical polymerizable group, optionally radical polymerizable group-substituted alkyl group, aryl group, or heterocyclic group; $X^1$, $X^4$, $X^5$ and $X^6$ each independently denote an oxygen atom, sulfur atom, selenium atom, or $CRa_2$, where Ra denotes a hydrogen atom or alkyl group; and $Y^3$ and $Y^4$ each independently denote an oxygen atom, sulfur atom, or selenium atom. In general formula (C-1), at least one from among $R^{11}$ to $R^{14}$ comprises a radical polymerizable group; in general formula (C-2), at least one from among $R^{21}$ and $R^{22}$ comprises a radical polymerizable group; in general formula (C-3), at least one from among $R^{31}$ to $R^{33}$ comprises a radical polymerizable group; in general formula (C-4), at least one from among $R^{41}$ to $R^{44}$ comprises a radical polymerizable group; in general formula (C-5), at least one from among $R^{51}$ to $R^{53}$ comprises a radical polymerizable group; and in general formula (C-6), at least one from among $R^{61}$ to $R^{63}$ comprises a radical polymerizable group.

**8.** The optical recording composition according to any of claims 1 to 7, which is a holographic recording composition.

**9.** A holographic recording medium comprising a recording layer, wherein the recording layer is formed with the holographic recording composition according to claim 8.

**10.** A method of recording and reproducing information comprising:

irradiating the holographic recording medium according to claim 9 with an informing light and a reference light to form an interference image in the recording layer comprised in the holographic recording medium; and irradiating the holographic recording medium in which the interference image has been formed with a reproduction light.

**11.** The method of recording and reproducing information according to claim 10, employing a light with a wavelength $\lambda_3$ nm satisfying the following equation (1) as the reproduction light.

$$(\lambda_3 - 100) \leq \lambda_1 < \lambda_3 \cdots (1)$$

Fig. 1

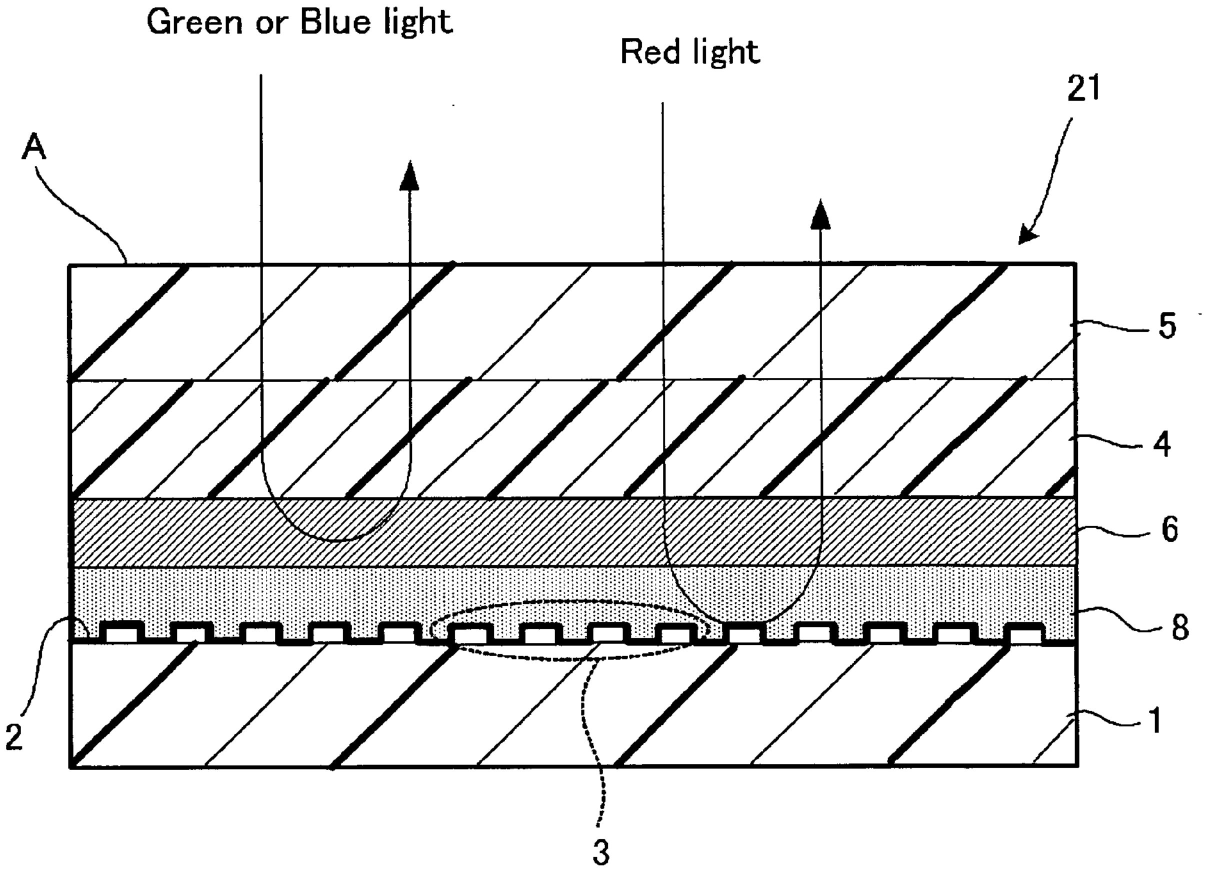

Fig. 2

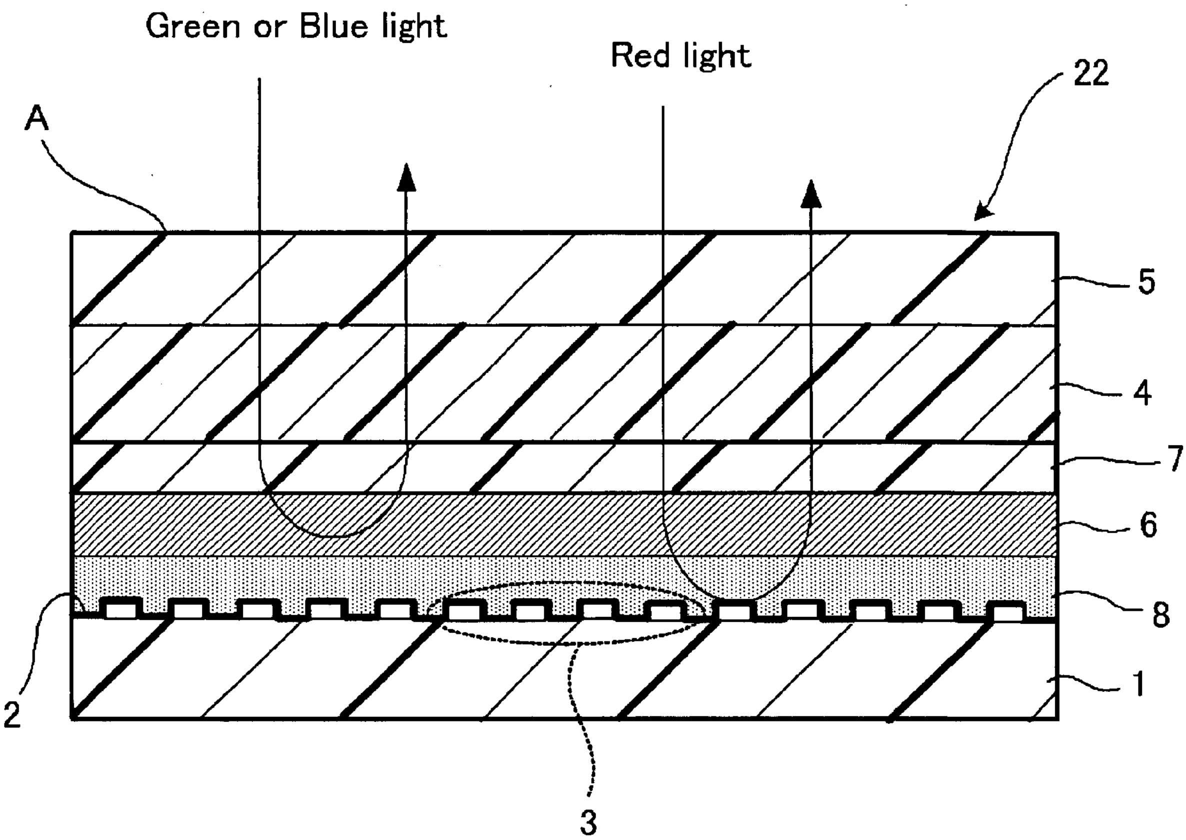

Fig. 3

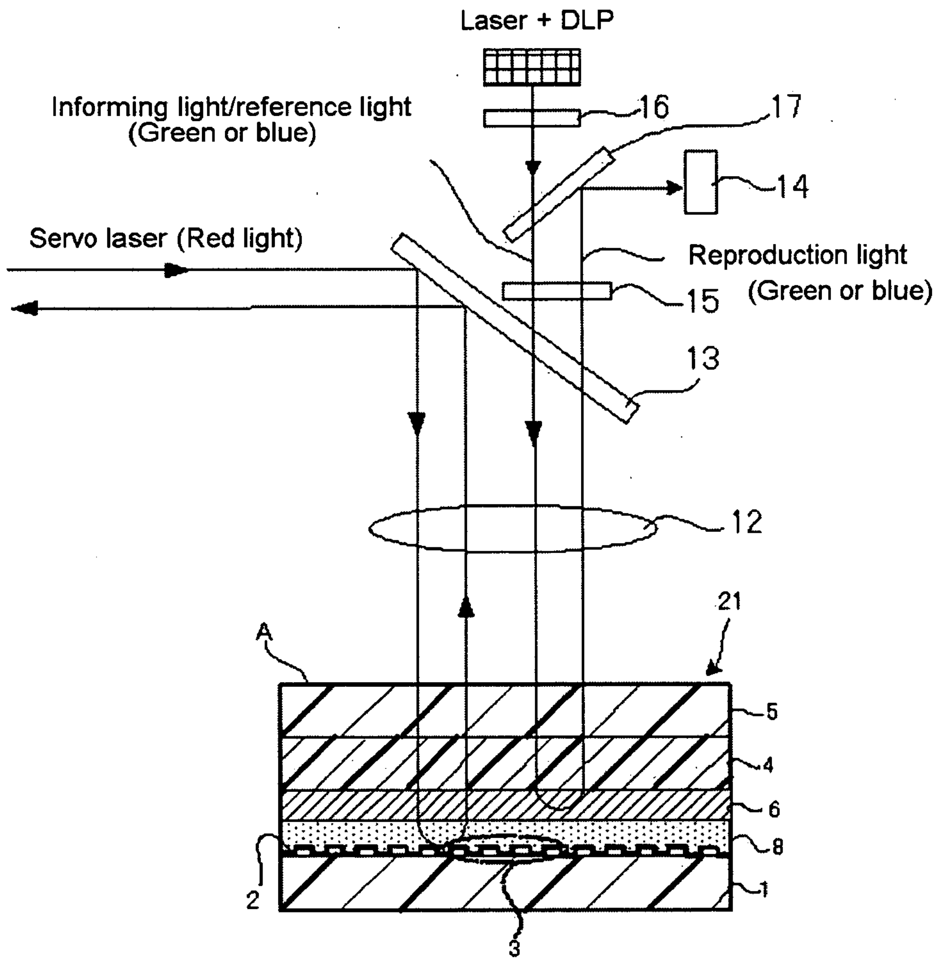
Laser + DLP
Informing light/reference light
(Green or blue)
16
17
14
Servo laser (Red light)
Reproduction light
(Green or blue)
15
13
12
21
A
5
4
6
8
1
2
3

Fig. 4

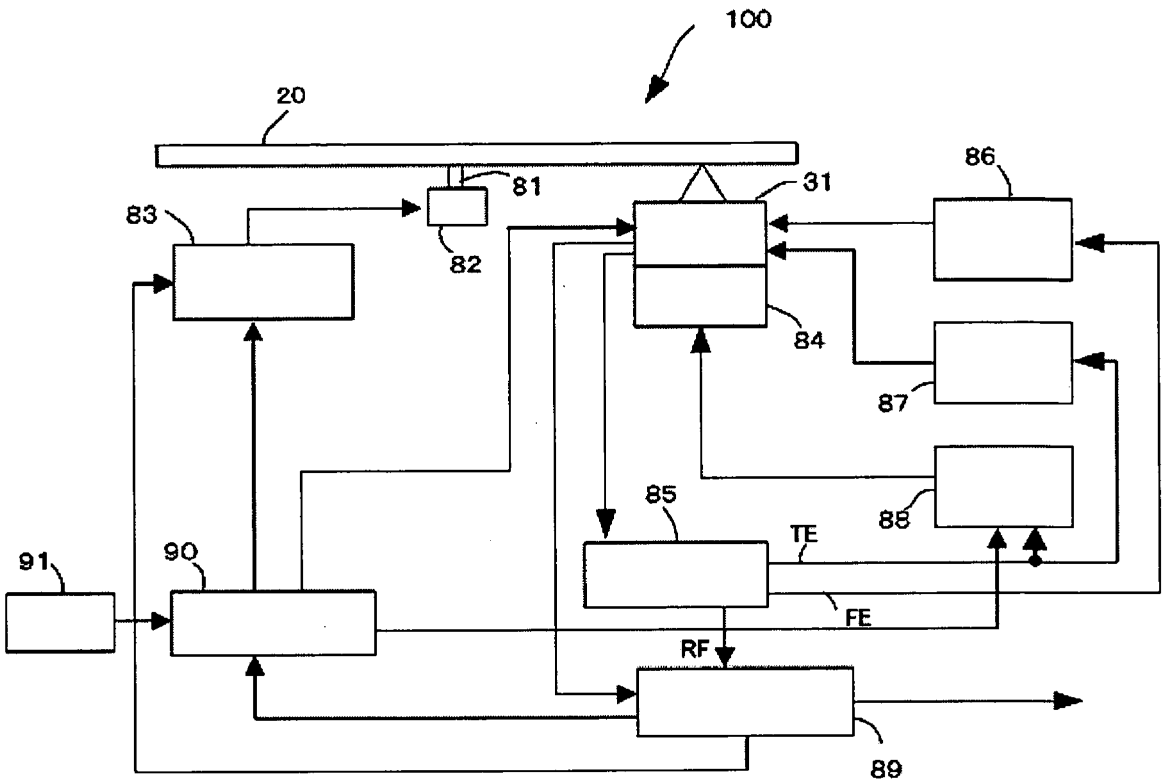

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002123949 A
- US 20040042374 A1
- JP 6043634 A
- US 4942112 A
- US 6482551 B
- JP 2005275158 A
- JP 61151197 A
- US 4713401 A
- JP 58015603 A
- JP 58040302 A
- JP 59028328 A
- JP 60053300 A
- JP 61009621 A
- JP 62003842 A
- JP 59089303 A
- JP 60060104 A


### Non-patent literature cited in the description


- *Research Disclosure,* December 1980, vol. 200
- Sensitizers. Kodansha, 1987, 160-163
- The Chemistry of Functional Dyes. CMC Press, 1981, 393-416
- *Coloring Materials,* 1987, vol. 60 (4), 212-224
- *ISOM' 04, Th-J-06,* October 2004, 184-185